(19) Europäisches Patentamt
European Patent Office
Office européen des brevets

(11) **EP 3 895 315 B1**

(12) **EUROPÄISCHE PATENTSCHRIFT**

(45) Veröffentlichungstag und Bekanntmachung des Hinweises auf die Patenterteilung:
**07.02.2024 Patentblatt 2024/06**

(21) Anmeldenummer: **19824255.4**

(22) Anmeldetag: **11.12.2019**

(51) Internationale Patentklassifikation (IPC):
**H03K 17/955** (2006.01)    **E05F 15/73** (2015.01)

(52) Gemeinsame Patentklassifikation (CPC):
**H03K 17/955;** E05F 15/73; E05Y 2400/858;
H03K 2217/960705; H03K 2217/960725;
H03K 2217/96078

(86) Internationale Anmeldenummer:
**PCT/EP2019/084593**

(87) Internationale Veröffentlichungsnummer:
**WO 2020/120549 (18.06.2020 Gazette 2020/25)**

(54) **ANORDNUNG FÜR EIN FAHRZEUG**

ASSEMBLY FOR A VEHICLE

SYSTÈME POUR UN VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.12.2018 DE 102018131867**

(43) Veröffentlichungstag der Anmeldung:
**20.10.2021 Patentblatt 2021/42**

(73) Patentinhaber: **Huf Hülsbeck & Fürst GmbH & Co. KG**
**42551 Velbert (DE)**

(72) Erfinder:
• **STAHL, Daniel**
**42549 Velbert (DE)**
• **SIEG, Berthold**
**46240 Bottrop (DE)**

(74) Vertreter: **Bals & Vogel Patentanwälte PartGmbB**
**Konrad-Zuse-Str. 4**
**44801 Bochum (DE)**

(56) Entgegenhaltungen:
WO-A1-2016/107910    DE-A1-102013 112 909
US-A1- 2008 252 303    US-B1- 8 564 313

**Beschreibung**

Die vorliegende Erfindung betrifft eine Anordnung für ein Fahrzeug zur Detektion einer Aktivierungshandlung für die Aktivierung einer Funktion am Fahrzeug. Ferner bezieht sich die Erfindung auf ein System sowie ein Verfahren.

Es ist aus dem Stand der Technik bekannt, dass mittels eines Sensorelements, wie einer Sensorelektrode, eine veränderliche Kapazität bereitgestellt werden kann, welche für Veränderungen in der Umgebung des Sensorelements spezifisch ist. Dies ermöglicht es, Änderungen in der Umgebung kapazitiv zu erfassen. Bei Fahrzeugen kann eine derartige kapazitive Erfassung genutzt werden, um Annäherungen und/oder Gesten zu detektieren, und damit Funktionen am Fahrzeug zu aktivieren.

Die kapazitive Erfassung basiert häufig darauf, dass das Sensorelement mittels einer Ladungsübertragung ausgewertet wird. Das Verschieben von elektrischen Ladungen kann jedoch störende Emissionen (Störauswirkungen des Sensorelements auf die Umgebung) bewirken. Ferner können störende Einflüsse aus der Umgebung (Immissionen auf den Sensor) die Erfassung beeinträchtigen.

Darüber hinaus sind auch weitere Störeinflüsse auf die Erfassung bekannt, z. B. störende kapazitive Einwirkungen (parasitäre Kapazitäten, kapazitive Lasten z. B. der Fahrzeugkarossiere, oder dergleichen).

Die WO 2016/107910 A1 offenbart einen kapazitativen Sensor, wobei der Sensor eine Sensorelektrode zur kapazitiven Kopplung mit einer Gegenelektrode umfasst, um eine zu messende Kapazität zu bilden, und eine Wechselspannungsquelle, die so konfiguriert ist, dass sie eine Wechselspannung an die Sensorelektrode koppelt.

Die US 2008/0252303 A1 offenbart eine kapazitative Detektionsvorrichtung.

Die US 8,564,313 B1 offenbart eine Vorrichtung sowie ein Verfahren für einen kapazitiven Sensor mit einem Sigma-Delta-Modulator.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte kapazitive Erfassung bereitzustellen.

Die voranstehende Aufgabe wird gelöst durch eine Anordnung mit den Merkmalen des unabhängigen Vorrichtungsanspruchs, ein System mit den Merkmalen des unabhängigen Systemanspruchs sowie durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen System sowie dem erfindungsgemäßen Verfahren, und jeweils umgekehrt, sodass bezüglich der Offenbarung zu den einzelnen Erfindungsaspekten stets wechselseitig Bezug genommen wird bzw. werden kann.

Die Aufgabe wird insbesondere gelöst durch eine Anordnung für ein Fahrzeug zur Detektion einer Aktivierungshandlung für die Aktivierung einer Funktion am Fahrzeug.

Hierbei ist insbesondere vorgesehen, dass die Aktivierungshandlung in einem Front-, Seiten- und/oder Heckbereich des Fahrzeuges durchgeführt wird, um bei der Detektion der Aktivierungshandlung die Aktivierung der Funktion in der Form einer Öffnung und/oder Entriegelung einer Klappe am Fahrzeug zu initiieren. Entsprechend kann die erfindungsgemäße Anordnung auch im Front-, und/oder Seiten- und/oder Heckbereich des Fahrzeuges angeordnet sein.

Eine erfindungsgemäße Anordnung weist dabei zumindest die nachfolgenden Komponenten auf, welche insbesondere mit einer Leiterplatte der Anordnung verbunden sind:

- wenigstens ein (insbesondere elektrisch leitfähiges) Sensorelement zur Erfassung einer Veränderung, vorzugsweise einer Annäherung durch ein Aktivierungsmittel, in einer Umgebung des Sensorelements,
- eine (insbesondere elektronische) Kontrollanordnung, um ein elektrisches Ansteuerungssignal für eine Durchführung wiederholter Ladungsübertragungen beim Sensorelement und/oder für eine kapazitive Sensorauswertung des Sensorelements zu erzeugen,
- eine (insbesondere elektronische) Übertragungsanordnung zur Bereitstellung eines elektrischen Sensorsignals anhand der wiederholten Ladungsübertragungen und/oder anhand des Ansteuerungssignals, wobei bevorzugt das Sensorsignal für die Ladungsübertragungen und/oder für einen Parameter, insbesondere einer veränderlichen Kapazität, des Sensorelements spezifisch ist,

- eine (insbesondere elektronische und/oder diodenfreie) Gleichrichteranordnung, welche zur Gleichrichtung des elektrischen Sensorsignals zwischen einer elektrischen Speicheranordnung und der Übertragungsanordnung verschaltet ist, vorzugsweise elektrisch direkt verbunden ist, um bei der Sensorauswertung das Sensorsignal gleichgerichtet an die Speicheranordnung zu übertragen, wobei die Gleichrichteranordnung mehrere Gleichrichter, vorzugsweise Einweggleichrichter oder Vollweggleichrichter, aufweist, welche mit der Kontrollanordnung und/oder Kontrollvorrichtung verschaltet sind, um mit unterschiedlichen Frequenzen, insbesondere getaktet und/oder kohärent und/oder synchronisiert zum elektrischen Ansteuerungssignal, angesteuert zu werden, derart, dass

- einer der Gleichrichter nur eine Halbschwingung des Sensorsignals gemäß einer Grundfrequenz, insbesondere einer ersten Harmonischen, des elektrischen Sensorsignals an die Speicheranordnung weiterleitet, und
- der wenigstens eine weitere Gleichrichter die Weiterleitung, insbesondere dieser Halbschwingung, des Sensorsignals gemäß weiterer Harmonischer des elektrischen Sensorsignals an die Speicheranordnung unterdrückt,

- eine (insbesondere elektronische) Kontrollvorrichtung, insbesondere einen Mikrocontroller, zur wiederholten Ermittlung wenigstens eines (des) für die Erfassung spezifischen Parameters, insbesondere einer (der) veränderlichen Kapazität (auch: Sensorkapazität), des Sensorelements anhand einer Auswertung bei der Speicheranordnung, insbesondere der darin gespeicherten Ladungsmenge, um die Detektion der Aktivierungshandlung anhand der Ladungsübertragungen für die Sensorauswertung durchzuführen.

Die Kontrollanordnung kann hierbei das Ansteuerungssignal erzeugen und insbesondere bei einer Sensorkontrollanordnung bereitstellen, um die Ladungsübertragungen am Sensorelement zu initiieren. In anderen Worten kann eine Auf- und Entladung des Sensorelements durch das Ansteuerungssignal bewirkt werden. Dies ermöglicht die kapazitive Sensorauswertung, da die hierbei übertragene Ladungsmenge von dem Parameter (insbesondere der Sensorkapazität) des Sensorelements abhängig ist. Die Nutzung eines Ansteuerungssignals hat dabei den Vorteil, dass eine Emission des Sensorelements und eine Störanfälligkeit für Immissionen sehr genau eingestellt werden kann. Dies kann z. B. durch die Anpassung einer Frequenz (Arbeitsfrequenz) und/oder Signalform des Ansteuerungssignals erfolgen. Um jedoch diese eingestellten Eigenschaften auch bei der Sensorauswertung nutzen zu können, kann das Sensorsignal ebenfalls entsprechend dem Ansteuerungssignal angepasst sein. Hierzu ist es vorteilhafterweise vorgesehen, dass die Übertragungsanordnung das Sensorsignal anhand der wiederholten Ladungsübertragungen und anhand des Ansteuerungssignals bereitstellt. Das Sensorsignal ist somit spezifisch für die Ladungsübertragungen und weist dennoch die eingestellten Eigenschaften auf. Hierzu wird z. B. eine Sensorkontrollanordnung genutzt, welche das Ansteuerungssignal in Abhängigkeit von den Ladungsübertragungen (und damit des Parameters) verstärkt als das Sensorsignal ausgibt. Dies ist z. B. durch den Einsatz eines Operationsverstärkers bei der Sensorkontrollanordnung möglich, welcher eine Gegenkopplung mittels eines Kondensators aufweist.

Um das Sensorsignal zuverlässig gemäß diesen eingestellten Eigenschaften zur Sensorauswertung zu nutzen, ist ferner die Gleichrichteranordnung vorgesehen. Da die Eigenschaften insbesondere durch die Nutzung und Parametrisierung eines periodischen, oszillierenden Signals als Ansteuerungs- und Sensorsignal eingestellt werden, kann die Gleichrichteranordnung gewährleisten, dass die Speicheranordnung durch das Sensorsignal nur aufgeladen und nicht entladen wird. Damit kann der Speicherzustand der Speicheranordnung besonders zuverlässig zur Sensorauswertung genutzt werden.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges und/oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt.

Es ist ferner denkbar, dass - für die Aktivierung der Funktion am Fahrzeug - durch eine erfindungsgemäße Anordnung eine Aktivierungshandlung detektiert wird. Es kann sich hierbei insbesondere um eine Aktivierungshandlung außerhalb des Fahrzeuges handeln (welche also nicht im Fahrzeuginnenraum stattfindet). In anderen Worten kann die Umgebung des Sensorelements, in welcher die Veränderung erfasst wird, sich außerhalb des Fahrzeuges befinden. Bei erfolgreicher Detektion der Aktivierungshandlung durch die erfindungsgemäße Anordnung kann dabei durch die Anordnung (insbesondere durch eine Kontrollvorrichtung) die Funktion ausgelöst und/oder die Authentifizierung initiiert werden. Bei der Aktivierungshandlung kann es sich z. B. um die Annäherung und/oder die Geste handeln, welche mittels des Aktivierungsmittels durchgeführt wird. Das Aktivierungsmittel bzw. die Aktivierungshandlung kann vorteilhafterweise auch dann detektiert werden, wenn es sich bei dem Aktivierungsmittel um ein nicht-elektronisches Objekt (und damit auch nicht um einen ID-Geber) handelt. Stattdessen kann das Aktivierungsmittel als eine nichtelektrische und/oder nicht-metallische und/oder biologische Substanz ausgeführt sein, wie z. B. ein Körperteil eines Benutzers. Daher ist die Nutzung einer kapazitiven Erfassung zur Detektion der Aktivierungshandlung besonders vorteilhaft, da dies keine besonderen Vorkehrungen am Aktivierungsmittel voraussetzt.

Eine erfindungsgemäße Anordnung ist vorteilhafterweise als eine elektronische Schaltung (Schaltungsanordnung) ausgebildet, und weist elektronische Komponenten auf, welche zumindest teilweise an einer Leiterplatte angeordnet und über elektrische Leiterbahnen miteinander verschaltet sein können. Wenigstens eine dieser Komponenten kann dabei auch als integrierter Schaltkreis ausgebildet sein (wie z. B. eine Kontrollvorrichtung in der Form eines Mikrocontrollers). Auch können einige der Komponenten als SMD (Surface-Mounted-Device) Bauelemente ausgebildet sein. Das Sensorelement kann elektrisch leitend z. B. als Leiterbahn oder als flächige Elektrode an der Leiterplatte ausgebildet sein, oder auch über eine Zuleitung (wie eine elektrische Leitung) mit der Leiterplatte verbunden sein. Im letzteren Fall ist das Sensorelement bspw. Teil eines Kabels (wie eines Koaxialkabels), als eine flächige Elektrode oder als langgestreckter Leiter ausgebildet. Das Sensorelement kann dabei auch als eine kapazitive Antenne aufgefasst werden, da durch das Sensorelement eine veränderliche Sensorkapazität bereitgestellt wird. Ferner kann die veränderliche Sensorkapazität optional auch durch mehrere Sensorelemente bereitgestellt werden, welche gleichzeitig oder abwechselnd betrieben werden. Die Leiterplatte und/oder das Sensorelement ist z. B. in einem Türgriff oder in einem Stoßfänger integriert. Das Sensorelement kann dabei derart angeordnet sein, dass die Anordnung des Sensorelements einen Detektionsbereich für die Aktivierungshandlung definiert.

Es ist bei einer erfindungsgemäßen Anordnung möglich, dass das Sensorelement als eine Sensorelektrode ausgebildet ist, um den für die Erfassung spezifischen Parameter als eine veränderliche Kapazität (auch Sensorkapazität bezeichnet) bereitzustellen, wobei die Veränderung der Kapazität für die Veränderung in der Umgebung des Sensorelements spezifisch sein kann. Wenigstens ein Schildelement kann wiederrum dazu dienen, eine Veränderung in einem abzuschirmenden Bereich der Umgebung vom Sensorelement abzuschirmen, sodass diese Veränderung nicht signifikant zur Veränderung der Kapazität führt.

Darüber hinaus kann es vorgesehen sein, dass für die Ansteuerung des Sensorelements ein Ansteuerungssignal genutzt wird, und für die Auswertung des Sensorelements ein Sensorsignal genutzt wird. Dabei kann das Sensorsignal vom Ansteuerungssignal abhängig sein. Auch kann eine Ladungsübertragung beim Sensorelement vom Ansteuerungssignal abhängig sein, da z. B. eine elektrische Spannung am Sensorelement dem Ansteuerungssignal folgt (bzw. der elektrischen Spannung des Ansteuerungssignals entspricht).

Es kann vorgesehen sein, dass das Sensorsignal und/oder die Ladungsübertragungen beim Sensorelement im Wesentlichen

- dieselbe Frequenz (Arbeitsfrequenz) aufweist, wie das Ansteuerungssignal, und/oder
- dieselbe Signalform aufweist, wie das Ansteuerungssignal, vorzugsweise Sinusform und/oder eine periodische oszillierende Form, und/oder
- eine Frequenz in einem Arbeitsfrequenzbereich aufweist, wobei auch die Frequenz (Arbeitsfrequenz) des Ansteuerungssignals in diesem Arbeitsfrequenzbereich liegt,
- phasengleich bzw. polaritätsgleich ausgeführt ist,
- einen gleichen Gleichspannungs- und/oder Gleichstromoffset (bzw. DC Offset) aufweist,
- ein reduziertes Frequenzspektrum aufweist, welches durch eine Filteranordnung und/oder eine Auswertefilteranordnung angepasst ist.

Ferner ist es denkbar, dass das Sensorsignal zumindest nach (oder durch) eine Filterung einer Auswertefilteranordnung als Wechselstrom (oder Wechselspannung) vorliegt. Eine Filterung kann durch die Auswertefilteranordnung auch als Bandpassfilterung ausgeführt sein. Dagegen kann eine Filterung des Ansteuerungssignals insbesondere durch die Filteranordnung als Tiefpassfilterung ausgeführt sein, um einen Gleichspannungsanteil beim Ansteuerungssignal beizubehalten.

Ferner kann es möglich sein, dass die Auswertefilteranordnung dazu ausgeführt ist, alternativ oder zusätzlich zur Bandpassfilterung eine Transkonduktanzwandlung des Sensorsignals durchzuführen. Unter einer Transkonduktanzwandlung wird dabei im Rahmen der Erfindung insbesondere verstanden, dass eine elektrische Spannung in einen dazu proportionalen und vorzugsweise gleichen elektrischen Strom umgewandelt wird. Funktional kann dies der Funktion eines Transkonduktanzverstärkers entsprechen, ggf. mit einem Verstärkungsfaktor (Proportionalitätsfaktor) von maximal 1. Jedoch kann im Gegensatz zum Transkonduktanzverstärker die Auswertefilteranordnung keinen Operationsverstärker aufweisen, sondern die Transkonduktanzwandlung mittels des komplexen Widerstands und insbesondere durch die Verschaltung in Serie mit dem virtuellen Nullpunkt erzielen.

Die Frequenz des Sensorsignals (als periodisches Signal) kann dabei abhängig sein von einer Arbeitsfrequenz, d. h. insbesondere der Frequenz des Ansteuerungssignals am Ausgang einer Filteranordnung der Kontrollanordnung. Es kann vorteilhafterweise für die gesamte erfindungsgemäße Anordnung eine einzige Arbeitsfrequenz sowohl für die Ansteuerung als auch für die Auswertung, insbesondere kapazitive Sensorauswertung, des Sensorelements genutzt werden, um die Ansteuerung und Auswertung des Sensorelements mit einem vorgegebenen Arbeitsfrequenzbereich durchzuführen. Hierzu wird insbesondere eine Filterung bei der elektrischen Ansteuerung (durch die Filteranordnung) und bei der Auswertung (durch eine Auswertefilteranordnung) genutzt, wobei die Filterung an die Arbeitsfrequenz angepasst ist (z. B. einen Tief- und/oder Bandpass zum Durchlassen des Arbeitsfrequenzbereiches ausbildet). Dies ermöglicht eine optimale Auswertung hinsichtlich EMV (Elektromagnetische Verträglichkeit) Bedingungen (bei Emissionen) und störenden Einwirkungen (bei Immissionen). Auch kann durch die Erzeugung des Ansteuerungssignals und/oder die Anpassung der Signalform und/oder Frequenz des Ansteuerungssignals eine Emission des Sensorelements und eine Störanfälligkeit für Immissionen sehr genau eingestellt werden. Um jedoch diese eingestellten Eigenschaften auch bei der Sensorauswertung nutzen zu können, kann das Sensorsignal ebenfalls entsprechend dem Ansteuerungssignal angepasst sein. Das Sensorsignal kann hierzu spezifisch sein für die Ladungsübertragungen und weist dennoch die eingestellten Eigenschaften auf. Hierzu wird z. B. eine (die) Sensorkontrollanordnung genutzt, welche das Ansteuerungssignal in Abhängigkeit von den Ladungsübertragungen (und damit der Sensorkapazität des Sensorelements) verstärkt als das Sensorsignal ausgibt. Dies ist z. B. durch den Einsatz eines Operationsverstärkers bei der Sensorkontrollanordnung möglich, welcher eine Gegenkopplung mittels eines Kondensators aufweist.

Bevorzugt kann die Speicheranordnung als ein elektronischer Integrator ausgeführt sein, insbesondere um empfangene Ladungen zu akkumulieren. Bevorzugt können mehrere Ladungsübertragungen nach mehreren Auf- und Entladungen des Sensorelements genutzt werden, um die Speicheranordnung aufzuladen.

Es ist insbesondere vorgesehen, dass nur eine bestimmte Halbwelle des Sinussignals, insbesondere in der Form eines Stromsignals, zur Speicheranordnung weitergeleitet wird, und bevorzugt die andere Halbwelle gesperrt wird. Es wird in anderen Worten nicht die Übertragungsanordnung direkt und dauerhaft mit dem Eingang der Speicheranordnung verbunden. Vielmehr ist es vorgesehen, dass die Übertragungsanordnung (ggf. über einen virtuellen Nullpunkt) wiederholt mit der Speicheranordnung verbunden und wieder davon getrennt wird. Entsprechend kann es eine erfindungsgemäße Besonderheit sein, dass die Übertragungsanordnung nur dann mit der Speicheranordnung verbunden wird, wenn auch eine bestimmte (wie die negative bzw. positive) Halbwelle durch die Gleichrichteranordnung durchgelassen wird. Ansonsten ist die Übertragungsanordnung von der Speicheranordnung elektronisch getrennt, und somit nicht für die Speicheranordnung bzw. die darin gespeicherte Ladung wirksam. In anderen Worten erfolgt die Ladungsübertragung an die Speicheranordnung nur beim Schalten der Gleichrichteranordnung. Die Übertragungsanordnung "sieht" ggf. somit entweder den virtuellen Nullpunkt oder ein Massepotential, sodass keine Ströme von der Speicheranordnung an die Übertragungsanordnung zurückfließen. Dies kann z. B. durch Schalter der Gleichrichteranordnung ermöglicht werden, welche zwischen dem virtuellen Nullpunkt der Gleichrichteranordnung und dem Massepotential umschalten, und zudem stets mit der Übertragungsanordnung verbunden sind. Die Integration und damit die Auswertung des Parameters kann somit robuster und/oder weniger störanfällig und/oder zuverlässiger erfolgen.

Die Übertragungsanordnung kann insbesondere eine Sensorkontrollanordnung zur Bereitstellung und insbesondere Erzeugung des Sensorsignals und/oder eine Auswertefilteranordnung zur Filterung des Sensorsignals aufweisen.

Zudem ist im Rahmen der Erfindung denkbar, dass die Gleichrichteranordnung wenigstens einen steuerbaren Gleichrichter, vorzugsweise Synchrongleichrichter, aufweist, welcher zur Gleichrichtung des Sensorsignals synchronisiert, insbesondere kohärent, d. h. insbesondere phasensynchron, zum Ansteuerungssignal ausgeführt ist. In anderen Worten ist der wenigstens eine Gleichrichter dazu ausgeführt, die Gleichrichtung des Sensorsignals synchronisiert, insbesondere kohärent, zum Ansteuerungssignal durchzuführen. Dies ermöglicht es, eine Signalform und/oder Frequenz für das Sensorsignal zu nutzen, welche auch das Ansteuerungssignal aufweist. Damit können nicht nur bei der Ansteuerung bestimmte Störfrequenzen vermieden werden, sondern auch bei der Sensorauswertung bestimmte Störfrequenzen unterdrückt werden. Alternativ kann hierzu ggf. auch eine inkohärente Gleichrichtung genutzt werden (d. h. unter Einsatz eines inkohärenten Demodulators, wie eines sog. Hüllkurvendemodulators).

Vorteilhafterweise kann im Rahmen der Erfindung vorgesehen sein, dass die Kontrollanordnung und/oder die Kontrollvorrichtung, vorzugsweise ein Mikrocontroller, mit der Gleichrichteranordnung verschaltet ist, um die Gleichrichteranordnung in Abhängigkeit von dem elektrischen Ansteuerungssignal und insbesondere einer Phase des elektrischen Ansteuerungssignals anzusteuern, sodass vorzugsweise die Gleichrichtung kohärent zum elektrischen Ansteuerungssignal und/oder synchronisiert zur elektrischen Ansteuerung des Sensorelements erfolgt. Durch die Gleichrichtung synchronisiert zur elektrischen Ansteuerung kann die Gleichrichtung auch kohärent zum elektrischen Ansteuerungssignal erfolgen. Die elektrische Ansteuerung ist z. B. die Signalerzeugung einer Signalgeneratoranordnung, um das Ansteuerungssignal zu erzeugen. Da es sich bei dem Ansteuerungssignal um ein periodisches Signal handeln kann, ist es möglich, durch eine getaktete Ansteuerung der Gleichrichteranordnung eine phasenkorrekte Gleichrichtung durchzuführen, welche somit kohärent zum Ansteuerungssignal ist. Die getaktete Ansteuerung kann somit zur Synchronisation erfolgen, um eine besonders störrobuste Auswertung zu ermöglichen.

Ferner kann im Rahmen der Erfindung vorgesehen sein, dass die Gleichrichteranordnung mehrere Gleichrichter, vorzugsweise Einweggleichrichter oder Vollweggleichrichter, aufweist, welche mit der Kontrollanordnung und/oder Kontrollvorrichtung verschaltet sind, um mit unterschiedlichen Frequenzen, insbesondere getaktet und/oder kohärent und/oder synchronisiert zum elektrischen Ansteuerungssignal, angesteuert zu werden, derart, dass

- einer der Gleichrichter nur eine Halbschwingung des Sensorsignals gemäß einer Grundfrequenz, insbesondere einer ersten Harmonischen, des elektrischen Sensorsignals an die Speicheranordnung weiterleitet, und
- der wenigstens eine weitere Gleichrichter die Weiterleitung, insbesondere dieser Halbschwingung, des Sensorsignals gemäß weiterer Harmonischer des elektrischen Sensorsignals an die Speicheranordnung unterdrückt, und/oder
- der wenigstens eine weitere Gleichrichter die andere Halbschwingung einer anderen Speicheranordnung weiterleitet (im Sinne einer Vollwegsgleichrichtung).

Auf diese Weise kann der Vorteil erzielt werden, dass nur die Anteile des Sensorsignals zur Aufladung der Speicheranordnung dienen, welche der Grundfrequenz entsprechen. Weitere Frequenzen gemäß den weiteren Harmonischen (z. B. dritte, fünfte, usw.) stellen jedoch Störfrequenzen dar, welche durch die weiteren Gleichrichter unterdrückt werden können.

Des Weiteren kann vorgesehen sein, dass die Gleichrichteranordnung wenigstens einen elektronischen Schalter aufweist, welcher jeweils über einen Steuerpfad mit der Kontrollanordnung und/oder Kontrollvorrichtung verschaltet ist, um insbesondere für bestimmte Halbschwingungen, insbesondere negative Halbschwingungen, des elektrischen Ansteuerungssignals die Speicheranordnung mit der Übertragungsanordnung zur Übertragung des elektrischen Sensorsignals elektrisch zu verbinden, wobei vorzugsweise ein Steuersignal des Steuerpfads zur Umschaltung des Schalters mit dem elektrischen Ansteuerungssignal synchronisiert ist. Der Steuerpfad kann hierzu z. B. als elektrische Leiterbahn einer Leiterplatte oder dergleichen ausgebildet sein. Dies ermöglicht eine zuverlässige Nutzung des Sensorsignals zur Aufladung der Speicheranordnung, ohne dass störende Entladungen der Speicheranordnung auftreten.

Außerdem kann es im Rahmen der Erfindung von Vorteil sein, dass die Gleichrichteranordnung mehrere, vorzugsweise wenigstens zwei oder wenigstens drei oder wenigstens vier, elektronische Schalter aufweist, welche durch die Kontrollanordnung und/oder Kontrollvorrichtung mit unterschiedlichen Frequenzen zur Unterdrückung von Harmonischen des elektrischen Sensorsignals angesteuert werden, um vorzugsweise wenigstens eine, insbesondere zweite und/oder dritte und/oder vierte, Harmonische des elektrischen Sensorsignals abzuschwächen. Somit kann die Störanfälligkeit deutlich reduziert werden. In anderen Worten kann die Speicheranordnung primär nur durch solche Frequenzen aufgeladen werden, welche der Arbeitsfrequenz entsprechen und/oder im Arbeitsfrequenzbereich liegen.

Weiter ist im Rahmen der Erfindung denkbar, dass die Gleichrichteranordnung dazu ausgebildet ist, durch wiederholte Umschaltungen (insbesondere nur) einen Ladungstransport durch das elektrische Sensorsignal in Richtung der Speicheranordnung an die Speicheranordnung weiterzuleiten, und vorzugsweise nur bei dieser Weiterleitung einen virtuellen Nullpunkt der Speicheranordnung mit der Übertragungsanordnung und insbesondere mit einer Kompensationsanordnung zu verbinden, und bevorzugt andernfalls die Übertragungsanordnung mit einem Massepotential zu verbinden. Auf diese Weise kann eine Belastung der Übertragungsanordnung reduziert werden, da diese nur ein Massepotential und ein dazu ähnliches Potential "sieht". Die Umschaltungen können dabei durch wiederholte Veränderung des Schaltzustands der Gleichrichteranordnung zwischen einem geschlossenen (geringer Widerstand) und geöffneten Schaltzustand (hoher Widerstand, Sperrwiderstand). Somit kann die Gleichrichteranordnung eine Zuschaltanordnung bilden.

Bevorzugt kann im Rahmen der Erfindung vorgesehen sein, dass eine Auswertefilteranordnung der Übertragungsanordnung vorgesehen ist, um das elektrische Sensorsignal für einen Ladungstransport an die Speicheranordnung gefiltert, insbesondere bandpassgefiltert, und vorzugsweise als sinusartiges Stromsignal, bereitzustellen. Dies ermöglicht es, Störfrequenzen einer Immission auf den Sensor bzw. auf die Sensorauswertung herauszufiltern.

Es kann weiter möglich sein, dass eine Sensorkontrollanordnung der Übertragungsanordnung vorgesehen und dazu ausgeführt ist, anhand der Ladungsübertragungen und anhand des Ansteuerungssignals ein elektrisches Spannungssignal mit einer bestimmten Frequenz und/oder Signalform, vorzugsweise sinusartigen Form, an einem Ausgang bereitzustellen, insbesondere auszugeben, und insbesondere eine Auswertefilteranordnung der Übertragungsanordnung dazu ausgeführt ist, für die Sensorauswertung das Spannungssignal in ein elektrisches Stromsignal mit der im Wesentlichen gleichen Signalform und/oder Frequenz umzuwandeln, sodass sich das Sensorsignal als das elektrische Stromsignal durch eine Transkonduktanzwandlung ergibt. Dies wird z. B. auch durch eine Verschaltung der Auswertefilteranordnung seriell zu einem virtuellen Nullpunkt der Speicheranordnung begünstigt. Hierzu ist die Auswertefilteranordnung z. B. direkt über die Gleichrichteranordnung mit der Speicheranordnung elektrisch verbunden. Auf diese Weise kann die Belastung der Auswertefilteranordnung reduziert werden.

Ferner ist es optional vorgesehen, dass das Sensorelement als eine Sensorelektrode ausgebildet ist, um den für die Erfassung spezifischen Parameter als eine veränderliche Kapazität bereitzustellen, wobei die Veränderung der Kapazität für die Veränderung in der Umgebung spezifisch ist, wobei die Anordnung dazu ausgeführt ist, zur wiederholten Ermittlung für die Sensorauswertung wiederholt die Ladungsübertragungen zwischen dem Sensorelement und der Übertragungsanordnung durchzuführen, und davon abhängig das Sensorsignal an die Speicheranordnung, insbesondere einen Integrator, auszugeben, sodass die durch die Speicheranordnung gespeicherte elektrische Ladung für die Veränderung der Kapazität spezifisch ist. In anderen Worten kann für aufeinanderfolgende Ladungsübertragungen eine Ladungsakkumulation durch die Speicheranordnung stattfinden. Auf diese Weise ist die akkumulierte Ladung spezifisch für die Kapazität, und ermöglicht damit eine zuverlässige Sensorauswertung zur Detektion der Aktivierungshandlung.

Zudem ist im Rahmen der Erfindung denkbar, dass die Kontrollvorrichtung mit der Speicheranordnung verschaltet ist, um eine durch die Speicheranordnung gespeicherte elektrische Ladung zur Ermittlung des für die Erfassung spezifischen Parameters auszuwerten, vorzugsweise durch eine Analog-Digital-Umwandlung einer Spannung bei der Speicheranordnung. Hierzu ist die Kontrollvorrichtung bspw. als Mikrocontroller mit einem Analog-Digital-Wandler ausgeführt. Dies ermöglicht eine Detektion der Aktivierungshandlung anhand der Spannung bei der Speicheranordnung. Insbesondere ein zeitlicher Verlauf der Spannung (und damit Veränderungen des Parameters bzw. der Sensorkapazität) können die Detektion ermöglichen.

Es ist ferner denkbar, dass die Anordnung dazu ausgeführt ist, wiederholt initiiert durch das Ansteuerungssignal das Sensorelement aufzuladen und/oder zu entladen, und nach der Aufladung und/oder Entladung zur Ermittlung des wenigstens einen für die Erfassung spezifischen Parameters des Sensorelements gemäß der Sensorauswertung eine elektrische Ladung von dem Sensorelement an die Übertragungsanordnung zu übertragen, und/oder umgekehrt. Diese Ladungsübertragungen können die Erzeugung des Sensorsignals beeinflussen. Ferner kann das Sensorsignal ebenfalls Ladungsübertragungen an die Speicheranordnung bewirken. Dabei kann die Kontrollvorrichtung, insbesondere wenigstens ein Mikrocontroller, mit einer Signalgeneratoranordnung elektrisch verbunden sein, um eine Erzeugung des Ansteuerungssignals bei der Signalgeneratoranordnung zu initiieren, und/oder mit der Speicheranordnung elektrisch verbunden sein, um nach den Ladungsübertragungen (an die Speicheranordnung) die Menge der in der Speicheranordnung gespeicherten und/oder nach mehreren Ladungsübertragungen akkumulierten Ladung auszuwerten, und anhand der Auswertung die Detektion durchzuführen, vorzugsweise um ein Aktivierungssignal zur Aktivierung der Funktion am Fahrzeug auszugeben, wenn die Ladungsmenge einen Grenzwert überschreitet.

Es kann von Vorteil sein, wenn im Rahmen der Erfindung die Anordnung als kapazitive Sensoranordnung zumindest teilweise in einem Stoßfänger des Fahrzeuges integriert ist, um den Heckbereich des Fahrzeuges zu überwachen, und um als die Funktion am Fahrzeug die Heckklappe (und/oder Frontklappe und/oder Schiebetür an einer Seite) des Fahrzeuges zu öffnen, insbesondere um eine Ausgabe eines Öffnungssignals und/oder eine Authentifizierungsprüfung zu initiieren. Damit ist ein komfortabler Zugang zum Fahrzeug ermöglicht.

Ebenfalls Gegenstand der Erfindung ist ein System aufweisend:

- eine erfindungsgemäße Anordnung,
- eine Kontrollvorrichtung zur Ausgabe eines Aktivierungssignals im Falle der Detektion der Aktivierungshandlung (durch die erfindungsgemäße Anordnung, wobei die Kontrollvorrichtung hierzu mit der erfindungsgemäßen Anordnung in signaltechnischer Verbindung steht),
- ein Steuergerät, welches mit der Kontrollvorrichtung (insbesondere signaltechnisch) verbunden ist, um bei Empfang des Aktivierungssignals die Funktion am Fahrzeug auszuführen.

Damit bringt das erfindungsgemäße System die gleichen Vorteile mit sich, wie sie ausführlich mit Bezug auf eine erfindungsgemäße Anordnung beschrieben worden sind.

Ebenfalls Gegenstand der Erfindung ist ein Verfahren für ein Fahrzeug zur Detektion einer Aktivierungshandlung für die Aktivierung einer Funktion am Fahrzeug, insbesondere in einem Front-, Seiten- und/oder Heckbereich des Fahrzeuges für die Aktivierung einer Öffnung und/oder Entriegelung einer Klappe am Fahrzeug.

Hierbei ist vorgesehen, dass die nachfolgenden Schritte durchgeführt werden, vorzugsweise nacheinander in der angegebenen oder in beliebiger Reihenfolge, wobei die Schritte ggf. auch zumindest teilweise zeitlich parallel und/oder synchronisiert und/oder wiederholt durchgeführt werden können:

- Erzeugen eines elektrischen Ansteuerungssignals,
- Durchführen wiederholter Ladungsübertragungen beim Sensorelement mittels des Ansteuerungssignals,
- Bereitstellen eines elektrischen Sensorsignals anhand der wiederholten Ladungsübertragungen und anhand des Ansteuerungssignals,
- Durchführen einer Übertragung des Sensorsignals gleichgerichtet an eine Speicheranordnung,
- Durchführen einer wiederholten Ermittlung wenigstens eines für die Erfassung spezifischen Parameters, insbesondere einer veränderlichen Kapazität, des Sensorelements anhand einer Auswertung bei der Speicheranordnung, insbesondere der darin gespeicherten Ladungsmenge, um die Detektion der Aktivierungshandlung anhand der Ladungsübertragungen durchzuführen.

Damit bringt das erfindungsgemäße Verfahren die gleichen Vorteile mit sich, wie sie ausführlich mit Bezug auf eine erfindungsgemäße Anordnung beschrieben worden sind. Zudem kann das Verfahren geeignet sein, eine erfindungsgemäße Anordnung zu betreiben.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:

Figur 1      eine schematische Ansicht auf einen Heckbereich eines Fahrzeuges mit einer erfindungsgemäßen Anordnung und einem erfindungsgemäßen System,

Figur 2      eine schematische Seitenansicht eines Fahrzeuges mit einer erfindungsgemäßen Anordnung und einem erfindungsgemäßen System,

Figur 3      ein schematisches Schaltbild von Teilen einer erfindungsgemäßen Anordnung,

Figur 4      ein schematisches Schaltbild von Teilen einer erfindungsgemäßen Anordnung,

Figur 5      eine schematische Darstellung von Teilen einer erfindungsgemäßen Anordnung bzw. eines erfindungsgemäßen Systems,

Figur 6      eine schematische Darstellung von Teilen einer erfindungsgemäßen Anordnung bzw. eines erfindungsgemäßen Systems, und

Figur 7      eine schematische Darstellung zur Visualisierung eines erfindungsgemäßen Systems.

In den nachfolgenden Figuren werden für die gleichen technischen Merkmale auch von unterschiedlichen Ausführungsbeispielen die identischen Bezugszeichen verwendet.

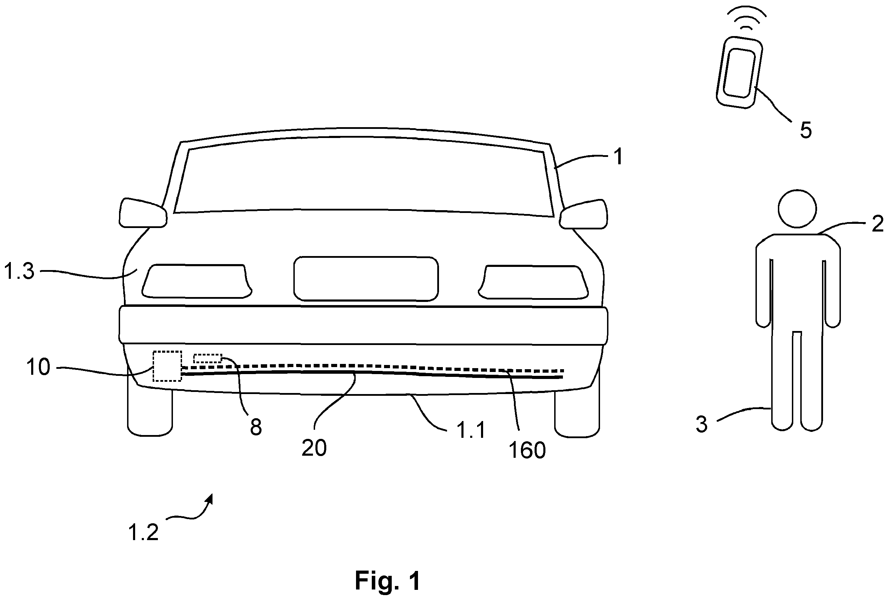

In Figur 1 ist eine Ansicht auf einen Heckbereich 1.2 eines Fahrzeuges 1 mit einem erfindungsgemäßen System gezeigt. Eine erfindungsgemäße Anordnung 10 kann in einem Stoßfänger 1.1 des Fahrzeuges 1 integriert sein, um eine Aktivierungshandlung durch ein Aktivierungsmittel 3 (wie ein Bein 3) eines Benutzers 2 im Bereich des Stoßfängers 1.1 zu detektieren. Hierzu weist die Anordnung 10 ein Sensorelement 20 auf, welches bspw. als langgestreckte und/oder kabelförmige Elektrode 20 oder als flächige Elektrode 20 (d. h. Flachelektrode) oder als kapazitive Antenne ausgebildet sein kann. Es ist ferner möglich, dass ein Kabel, wie ein Koaxialkabel, zur Ausbildung des Sensorelements 20 genutzt wird. Eine Detektion der Aktivierungshandlung kann dazu führen, dass eine Heckklappe 1.3 des Fahrzeuges 1 geöffnet wird. Zu diesem Zweck kann die Anordnung 10 eine Signalverbindung mit einem Steuergerät 8 des Fahrzeuges 1 aufweisen, um über die Signalverbindung ein Aktivierungssignal an das Steuergerät 8 auszugeben, welches die Öffnung der Heckklappe 1.3 initiiert. Vorausgesetzt werden kann für die Öffnung ggf. eine erfolgreiche Authentifizierung mit einem Identifikationsgeber 5. In gleicher Weise kann ggf. auch eine Klappe, insbesondere Tür 1.6, im Frontbereich 1.7 und/oder im Seitenbereich 1.4 des Fahrzeuges durch eine erfindungsgemäße Anordnung 10 aktiviert werden, wobei die Anordnung 10 dann z. B. im Türgriff 1.5 oder ebenfalls im Stoßfänger 1.1 oder an einem Seitenschweller integriert ist.

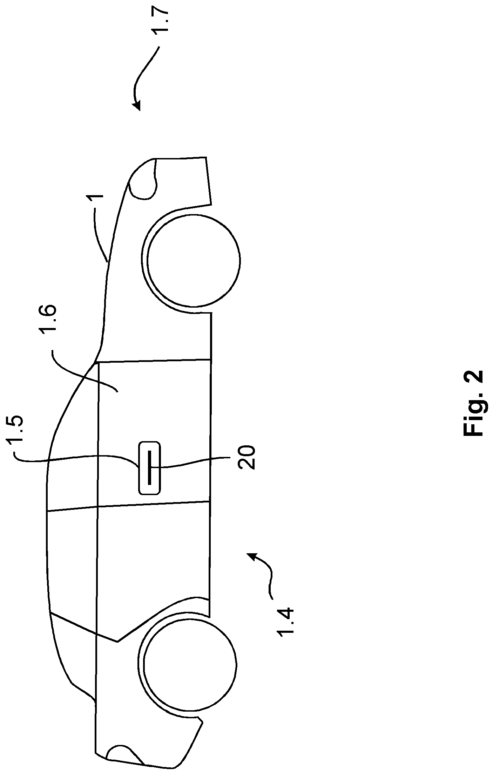

In Figur 2 ist schematisch ein Fahrzeug 1 in einer Seitenansicht gezeigt. Der Seitenbereich 1.4 und/oder der Frontbereich 1.7 des Fahrzeuges 1 kann alternativ oder zusätzlich zum Heckbereich 1.2 eine erfindungsgemäße Anordnung 10 aufweisen. Bspw. ist das Sensorelement 20 im Seitenbereich 1.4 in einen Türgriff 1.5 des Fahrzeuges integriert, um die Aktivierungshandlung im Bereich des Türgriffes 1.5 zu detektieren. So kann bspw. als eine Aktivierungshandlung eine Annäherung an das Sensorelement 20 durch die Anordnung 10 im Seitenbereich 1.4 detektiert werden. Diese Aktivierungshandlung kann ein Hineingreifen eines Aktivierungsmittels 3 (wie einer Hand) in eine Türgriffmulde des Türgriffs 1.5 umfassen. Die Anordnung des Sensorelements 20 im Frontbereich 1.7 kann wiederum im Stoßfänger 1.1 vorgesehen sein, um z. B. bei der Detektion der Aktivierungshandlung im Frontbereich 1.7 eine Frontklappe zu öffnen. Eine weitere mögliche Funktion, welche durch eine Aktivierungshandlung aktivierbar ist, kann die Öffnung von Schiebetüren 1.6 des Fahrzeuges 1 sein., z. B. durch Annäherung an einen Seitenschweller des Fahrzeuges.

Grundsätzlich kann die Aktivierungshandlung eine Annäherung an das Sensorelement 20 oder auch eine Geste oder dergleichen umfassen. Insbesondere zur Detektion von Gesten kann neben einem einzigen Sensorelement 20 noch wenigstens ein weiteres Sensorelement 20' vorgesehen sein, und benachbart zum Sensorelement 20 angeordnet sein. Dies ermöglicht es, eine Bewegung des Aktivierungsmittels durch die unterschiedliche Erfassung der Sensorelemente 20, 20' zu erkennen. Ebenfalls kann benachbart zum Sensorelement 20 und/oder weiteren Sensorelement 20' ein Schildelement 160 zur Abschirmung angeordnet sein. In Figur 1 ist beispielhaft diese Anordnung im Stoßfänger 1.1 gezeigt.

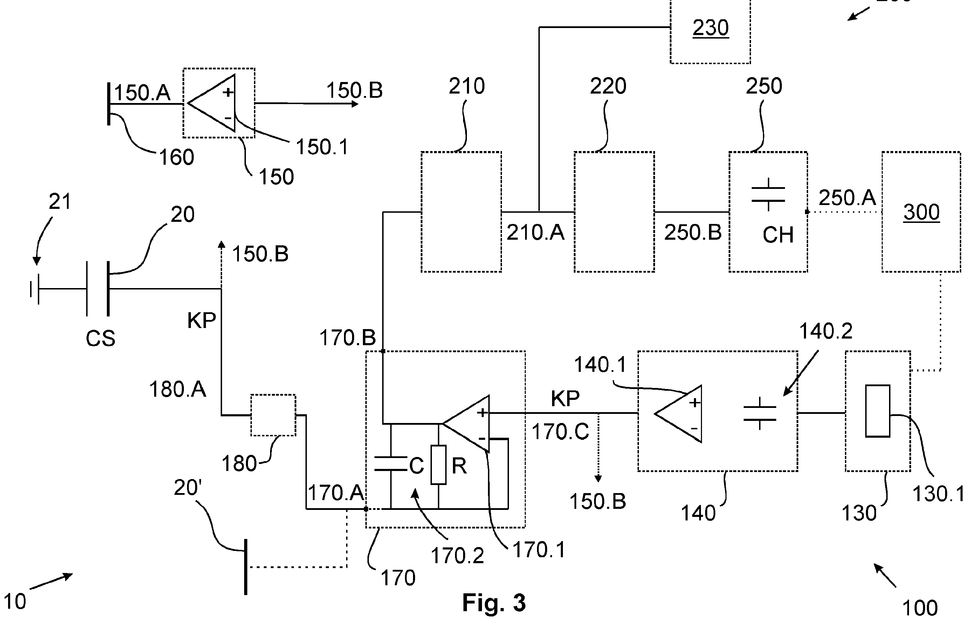

In Figur 3 ist eine erfindungsgemäße Anordnung 10 für ein Fahrzeug 1 gezeigt, welche zur Detektion einer Aktivierungshandlung für die Aktivierung einer Funktion am Fahrzeug 1, insbesondere wie gemäß Figur 1 und 2 beschrieben zur Detektion der Aktivierungshandlung in einem Front-, Seiten- und/oder Heckbereich 1.7, 1.4, 1.2 des Fahrzeuges 1 für die Aktivierung einer Öffnung und/oder Entriegelung einer Klappe 1.3, 1.6, insbesondere Tür 1.6, am Fahrzeug 1, dient.

Die erfindungsgemäße Anordnung 10 kann wenigstens ein Sensorelement 20 zur Erfassung einer Veränderung in einer Umgebung des Sensorelements 20 aufweisen. Diese Veränderung ist bspw. durch die Aktivierungshandlung bedingt, bspw. eine Annäherung durch ein Aktivierungsmittel 3. Das Sensorelement 20 kann dabei als ein elektrischer Leiter, wie eine elektrisch leitfähige Fläche (insbesondere bei einer Montage der Anordnung 10 im Türgriff 1.5) oder eine langgestreckte und ggf. flächige Elektrode (insbesondere bei einer Montage im Stoßfänger 1.1) ausgebildet sein.

Die Sensitivität des Sensorelements 20 für Veränderungen in der Umgebung und damit für die Aktivierungshandlung kann bspw. wie folgt vereinfacht erklärt werden. Gegenüber der Umgebung und/oder einem Massepotential 21 kann das Sensorelement 20 eine Kapazität (im Folgenden auch als Sensorkapazität CS bezeichnet) ausbilden. Durch die Erzeugung eines elektrischen Potentials (mittels einer nachfolgend beschriebenen elektrischen Ansteuerung) an dem Sensorelement 20 kann ein elektrisches Feld in der Umgebung entstehen. Die Sensorkapazität CS wird durch die Veränderung in der Umgebung beeinflusst und ist somit veränderlich. In anderen Worten korreliert die Veränderung der Sensorkapazität CS mit der Veränderung in der Umgebung, d. h. dem Vorliegen einer Aktivierungshandlung. Eine Auswertung der veränderlichen Kapazität CS kann insbesondere durch eine Auswertung der im Sensorelement 20 gespeicherten Ladungsmenge erfolgen und Rückschlüsse auf die Veränderung in der Umgebung bieten, und somit zur Detektion der Aktivierungshandlung dienen. Somit ist insbesondere die Durchführung von Ladungsübertragungen von und zu dem Sensorelement 20 geeignet, anhand der Ladungsübertragungen (wie der übertragenen Ladungsmenge und/oder der dabei erfassbaren Stromstärke und/oder Spannung) ein Sensorsignal bereitzustellen, welches für die Bestimmung der veränderlichen Kapazität CS ausgewertet werden kann.

Um die elektrische Ansteuerung durchzuführen, kann eine Kontrollanordnung 100 (im Sinne einer Steuerungsanordnung 100) genutzt werden. Die Kontrollanordnung 100 kann zur elektrischen Ansteuerung des Sensorelements 20 über einen Kontrollpfad KP mit dem Sensorelement 20 elektrisch verschaltet sein, um die Erfassung bereitzustellen (d. h. zu ermöglichen). Durch die elektrische Ansteuerung kann z. B. eine (zwangsgeführte) Auf- und Entladung des Sensorelements 20 über Ladungsübertragungen initiiert werden, um anhand dieser Ansteuerung des Sensorelements 20 die kapazitive Erfassung zu erlauben. Die elektrische Verschaltung kann z. B. mittels einer elektrischen Verbindung über Leiterbahnen einer Leiterplatte realisiert werden. Die erfindungsgemäße Anordnung 10 kann zumindest teilweise an dieser Leiterplatte als elektrische Schaltung angeordnet sein. Das Sensorelement 20 und/oder das weitere Sensorelement 20' und/oder das wenigstens eine Schildelement 160 kann dabei über einen elektrischen Anschluss der Leiterplatte mit der Kontrollanordnung 100 der Anordnung 10 über Leiterbahnen elektrisch verbunden sein, oder auch selbst als Leiterbahn ausgebildet sein. Die Erfassung wird bspw. dadurch bereitgestellt, dass ein elektrisches Potential durch die Kontrollanordnung 100 am Sensorelement 20 erzeugt wird, um das Sensorelement 20 aufzuladen, und damit wie zuvor beschrieben z. B. die Auswertung der veränderlichen Kapazität CS ermöglicht. Es kann sich dabei auch um ein wechselndes Potential handeln, sodass eine elektrische Spannung am Sensorelement 20 z. B. als periodische und/oder sinusförmige Spannung erzeugt wird. Zur Auswertung des Sensorelements 20 ist eine Auswerteanordnung 200 vorgesehen, welche eine wiederholte Ermittlung wenigstens eines für die Erfassung spezifischen Parameters des Sensorelements 20 durchführt, um die Detektion der Aktivierungshandlung durchzuführen. Im konkret beschriebenen Beispiel wird die veränderliche Kapazität CS als dieser Parameter angesehen.

Darüber hinaus ist es möglich, dass wenigstens ein Schildelement 160 vorgesehen ist, welches zur Abschirmung des Sensorelements 20 benachbart (und damit im Wirkbereich) zum Sensorelement 20 angeordnet ist. Um eine Abschirmung durch das Schildelement 160 zu ermöglichen, ist eine Schildkontrollanordnung 150 mit einem Anschluss 150.A für das Schildelement 160 vorgesehen. Die Schildkontrollanordnung 150 kann über einen Schildkontrolleingang 150.B zur Bereitstellung der (zuvor beschriebenen) elektrischen Ansteuerung der Kontrollanordnung 100 für das Schildelement 160 elektrisch mit dem Kontrollpfad KP und somit auch mit dem Schildelement 160 verbunden sein. In anderen Worten kann die Schildkontrollanordnung 150 die gleiche elektrische Ansteuerung für das Schildelement 160 bereitstellen, welche auch für das Sensorelement 20 genutzt wird. Hierzu folgt eine elektrische Ausgangsspannung an dem Ausgang 150.A der Schildkontrollanordnung 150, welcher elektrisch mit dem Schildelement 160 verbunden ist, einer Eingangsspannung an dem Eingang 150.B der Schildkontrollanordnung 150, welcher wiederum elektrisch mit dem Kontrollpfad KP verbunden und damit auch mit dem Sensorelement 20 verschaltet ist. Für das Sensorelement 20 und für das Schildelement 160 kann auf diese Weise ein gleiches Ansteuerungssignal genutzt werden, um durch das Ansteuerungssignal das Potential am Sensorelement 20 und am Schildelement 160 in gleicher Weise einzustellen.

Zur Verbindung der Schildkontrollanordnung 150 mit dem Kontrollpfad KP kann ein Verbindungspunkt am Kontrollpfad KP genutzt werden. Hierzu kommen verschiedene Positionen am Kontrollpfad KP in Frage, z. B. unmittelbar am Strompfad zum Sensorelement 20 oder zwischen einer Filteranordnung 140 und einer Sensorkontrollanordnung 170. In Figur 3 sind beispielhaft und nicht abschließend mit gestrichelter Linie zwei mögliche Verbindungspunkte des Schildkontrolleingangs 150.B mit der Schildkontrollanordnung 150 gezeigt. Bei Verwendung des Verbindungspunkts am Anschluss 170.C der Sensorkontrollanordnung 170 kann zur Einstellung des Potentials am Schildelement 160 das Ansteuerungssignal genutzt werden, welches durch die Filteranordnung 140 ausgegeben wird. Bei der Verwendung des Verbindungspunkts unmittelbar am Strompfad zum Sensorelement 20 wird zur Einstellung des Potentials am Schildelement 160 das (im Wesentlichen) gleiche Potential genutzt, welches am Sensorelement 20 anliegt.

Um die elektrische Ansteuerung besonders zuverlässig anzugleichen, und insbesondere dabei die Komponenten am Verbindungspunkt (wie das Sensorelement 20 bzw. die Kontrollanordnung 100) nicht übermäßig zu belasten, kann die Schildkontrollanordnung 150 zur elektrischen Zwangsführung des Schildelements 160 einen Operationsverstärker 150.1 aufweisen. Dieser kann genutzt werden, um den Kontrollpfad KP mit dem Schildelement 160 zu verbinden, und so die Ausgangsspannung (auch bezeichnet als Schildspannung) am Schildelement 160 gleich zur Eingangsspannung am Kontrollpfad KP zu erzeugen. Die Eingangsspannung entspricht dabei einer Ansteuerungsspannung, welche für die elektrische Spannung am Sensorelement 20 spezifisch und/oder dazu proportional ist. Bevorzugt kann die Schildkontrollanordnung 150 einen Spannungsfolger ausbilden, sodass ein elektrisches Potential an dem Schildelement 160 dem elektrischen Potential am Kontrollpfad KP und insbesondere am Sensorelement 20 folgt. Es kann entsprechend eine direkte Gegenkopplung des Operationsverstärkers 150.1 vorgesehen sein, um einen Verstärkungsfaktor von 1 zu erhalten. Der Schildkontrolleingang 150.B kann dabei (direkt) mit dem positiven (nicht invertierenden hochohmigen) Eingang des Operationsverstärkers 150.1 elektrisch verbunden sein, sodass der Eingangswiderstand des Schildkontrolleingangs 150.B sehr groß ist, um die Spannung am Schildkontrolleingangs 150.B nur gering zu belasten. Der Schildelementanschluss 150.A kann hingegen mit dem Ausgang des Operationsverstärkers 150.1 und aufgrund der Gegenkopplung ggf. auch mit dem invertierenden Eingang des Operationsverstärkers 150.1 (direkt) elektrisch verbunden sein, um einen im Vergleich zum Eingangswiderstand niederohmigen Ausgang bereitzustellen.

Ferner ist anhand Figur 3 erkennbar, dass die Kontrollanordnung 100 eine Signalgeneratoranordnung 130 aufweist, welche für die elektrische Ansteuerung des Sensorelements 20 mit dem Sensorelement 20 elektrisch verschaltet ist, um ein elektrisches Signal zur Aufladung des Sensorelements 20 wiederholt zu erzeugen. Dieses elektrische Signal, nachfolgend auch als Ansteuerungssignal bezeichnet, kann zur beschriebenen elektrischen Ansteuerung dienen, und damit für das Sensorelement 20, ggf. auch für das weitere Sensorelement 20', und insbesondere auch für das wenigstens eine Schildelement 160 zur Einstellung des elektrischen Potentials und/oder zur elektrischen Auf- und Entladung bereitgestellt werden. Diese Bereitstellung erfolgt z. B. durch die Übertragung des elektrischen Signals über zumindest einen Teil des Kontrollpfads KP an eine Sensorkontrollanordnung 170 und/oder an eine Schildkontrollanordnung 150. Die Erzeugung des Ansteuerungssignals durch die Signalgeneratoranordnung 130 bewirkt somit, dass das Ansteuerungssignal (ggf. zuvor verändert, insbesondere gefiltert) am Anschluss 170.C vorliegt. Durch die Sensorkontrollanordnung 170 und/oder Schildkontrollanordnung 150 kann wiederum anhand des Ansteuerungssignals das Sensorelement 20, das weitere Sensorelement 20' und/oder das Schildelement 160 angesteuert werden. Hierzu wird anhand des Ansteuerungssignals eine Ladungsübertragung (Auf- und/oder Entladung) bei dem Sensorelement 20 bzw. das weitere Sensorelement 20' und/oder das Schildelement 160 initiiert (und damit auch die Entstehung eines elektrischen Feldes initiiert). Die Auswertung der Menge der übertragenen Ladung kann eine Auswertung der veränderlichen Sensorkapazität CS ermöglichen. Der zeitliche Verlauf dieser Ladungsübertragung kann durch die Formung des elektrischen Signals beeinflusst werden. Hierzu weist die Signalgeneratoranordnung 130 z. B. einen Digital-Analog-Konverter 130.1 auf, welcher auch als Teil einer Kontrollvorrichtung 300 wie eines Mikrocontrollers ausgeführt sein kann. Auch kann die Signalgeneratoranordnung 130 ggf. vollständig Teil der Kontrollvorrichtung 300 sein. Auch ist es denkbar, dass die Signalgeneratoranordnung 130 nur teilweise in die Kontrollvorrichtung 300 integriert ist, und z. B. der Digital-Analog-Konverter 130.1 separat davon ausgebildet ist. Damit kann sehr zuverlässig und genau eine bestimmte Signalform des Ansteuerungssignals bestimmt werden. Diese Signalform kann durch eine anschließende Filterung ggf. weiter geformt und/oder verbessert werden, sodass das Ansteuerungssignal anschließend bspw. eine Sinusform gemäß einer Arbeitsfrequenz aufweist. Daher kann die Kontrollanordnung 100 eine Filteranordnung 140, insbesondere ein aktives Filter 140 z. B. ein Tiefpassfilter, aufweisen. Diese kann wie gezeigt der Signalgeneratoranordnung 130 nachgeschaltet sein, um das Ansteuerungssignal zur elektrischen Ansteuerung des Sensorelements 20 über den Kontrollpfad KP gefiltert an die Sensorkontrollanordnung 170 auszugeben, insbesondere durch eine Tiefpassfilterung. Auf diese Weise lässt sich das Ansteuerungssignal mit einer bestimmten Arbeitsfrequenz formen, sodass vorzugsweise eine Emission des Sensorelements 20 durch die Filteranordnung 140 angepasst ist. Damit können vorteilhafterweise EMV (Elektromagnetische Verträglichkeit) Vorgaben bei dem Betrieb der Anordnung 10 umgesetzt werden. In anderen Worten kann die Kontrollanordnung 100 eine Filteranordnung 140, insbesondere ein aktives Filter 140, aufweisen, welches die Signalgeneratoranordnung 130 mit dem Kontrollpfad KP verbindet, um ein durch die Signalgeneratoranordnung 130 erzeugtes elektrisches Signal am Kontrollpfad KP gefiltert, insbesondere tiefpassgefiltert, und/oder geformt bereitzustellen, und dadurch als ein gefiltertes elektrisches Signal, vorzugsweise Sinussignal, bereitzustellen. Die aktive Filterung wird dabei vorzugsweise durch einen Operationsverstärker 140.1 und durch Filterelemente 140.2 wie wenigstens einen Kondensator und/oder wenigstens einen Widerstand und/oder wenigstens eine Spule ermöglicht.

Das elektrische Signal (Ansteuerungssignal) am Kontrollpfad KP und insbesondere am Anschluss 170.C kann nun ggf. über weitere Komponenten wie der Sensorkontrollanordnung 170 und über ein Schaltelement 180 (ggf. über einen Anschluss 180.A) an das Sensorelement 20 ausgegeben werden. Um die hierdurch bewirkte Ladungsübertragung an das Sensorelement 20 zu unterbrechen und z. B. wenigstens ein weiteres Sensorelement 20' aufzuladen, kann das Schaltelement 180 getaktet geöffnet und anschließend wieder geschlossen werden. Die Sensorkontrollanordnung 170 kann einen Verstärker und/oder einen Spannungsfolger und/oder einen Spannungsvervielfacher aufweisen, um ein elektrisches Potential am Anschluss 170.C in gleicher Weise am Sensorelement 20 zu erzeugen, bevorzugt sodass das elektrische Potential am Sensorelement 20 dem elektrischen Potential am Anschluss 170.C folgt. Hierzu weist die Sensorkontrollanordnung 170 z. B. einen Operationsverstärker 170.1 und/oder wenigstens ein Filterelement 170.2, wie einen Kondensator 170.2, auf. Ein weiteres Schaltelement 180 kann z. B. im Pfad zwischen dem Anschluss 170.A und dem weiteren Sensorelement 20' integriert sein, und z. B. im Wechsel mit dem Schaltelement 180 geschaltet werden.

Die Sensorkontrollanordnung 170 kann den Operationsverstärker 170.1 als ein Übertragungselement 170.1 aufweisen, welches mit der Signalgeneratoranordnung 130 elektrisch verschaltet ist, um anhand des Ansteuerungssignals (am Anschluss 170.C) wiederholte Ladungsübertragungen bei dem Sensorelement 20 zu initiieren. Dies ermöglicht eine zumindest teilweise Auf- und wieder Entladung des Sensorelements 20, und damit eine Auswertung der im Sensorelement 20 gespeicherten Ladung. Hierzu kann bspw. eine Menge (Anzahl) der übertragenen Ladungen und/oder eine Stromstärke bei den Ladungsübertragungen ausgewertet werden. Die Ladungsmenge und/oder Stromstärke ist dann spezifisch für Sensorkapazität CS, insbesondere für die Veränderung der Sensorkapazität CS. Für diese Auswertung des Sensorelements 20 kann die Sensorkontrollanordnung 170 ferner das wenigstens eine Filterelement 170.2 als ein Verstärkungsmittel 170.2 aufweisen, welches mit der Auswerteanordnung 200 (und auch mit dem Sensorelement 20) elektrisch verschaltet ist, und so anhand der Ladungsübertragungen das Sensorsignal bereitstellt. Das Sensorsignal ist spezifisch für die (z. B. proportional zur) Sensorkapazität CS. Konkret ist das Sensorsignal z. B. spezifisch für die Stromstärke des elektrischen Stroms und/oder einer Spannung, welche(r) am Anschluss 170.A vorliegt, und damit spezifisch für die Ladungsübertragungen bzw. die Sensorkapazität CS.

Um anhand des Sensorsignals Rückschlüsse auf die Sensorkapazität CS zu ermöglichen, kann das Verstärkungsmittel 170.2, wie in Figur 3 dargestellt ist, mit dem Sensorelement 20 elektrisch verschaltet sein, um Ladungsübertragungen (also einen elektrischen Stromfluss) zwischen dem Sensorelement 20 und dem Verstärkungsmittel 170.2 bereitzustellen. Ferner kann das Verstärkungsmittel 170.2 einen Ausgang des Übertragungselements 170.1 mit einem (insbesondere invertierenden) ersten Eingang des Übertragungselements 170.1 elektrisch verbinden, sodass das Verstärkungsmittel 170.2 eine Gegenkopplung für das Übertragungselement 170.1 ausbildet. Die Gegenkopplung ermöglicht es, dass die Ladungsübertragungen durch das Ansteuerungssignal gesteuert werden, wenn das Ansteuerungssignal am anderen (insbesondere nicht invertierenden) zweiten Eingang des Übertragungselements 170.1 anliegt. Wenn der erste Eingang direkt mit dem Anschluss 170.A elektrisch verbunden ist, wie es auch in Figur 3 gezeigt ist, wird auf diese Weise durch die Sensorkontrollanordnung 170 ein Spannungsfolger für das Sensorelement 20 bereitgestellt, sodass die Spannung am (insbesondere niederohmigen) Anschluss 170.A dem Ansteuerungssignal am (insbesondere hochohmigen) Anschluss 170.C folgt. Dies entspricht der Steuerung der Ladungsübertragungen am Anschluss 170.A durch das Ansteuerungssignal, und damit einer (insbesondere niederohmigen) Sensorspeisung. Das Sensorsignal kann hingegen mittels der Anordnung (Verstärkeranordnung) aus dem Übertragungselement 170.1 und dem Verstärkungsmittel 170.2 bereitgestellt werden, bei welcher es sich um einen elektronischen Verstärker handeln kann.

Vorzugsweise ist das Übertragungselement 170.1 als Operationsverstärker 170.1 ausgebildet. Das Verstärkungsmittel 170.2 weist hingegen wenigstens ein oder zwei Filterelement(e) 170.2 auf, bei welchen jedoch ein Kondensator C (z. B. gegenüber einem Widerstand R) dominieren kann. Damit kann die Konfiguration der Anordnung aus dem Übertragungselement 170.1 und dem Verstärkungsmittel 170.2 auch als eine Integrier-Schaltung angesehen werden. Der Kondensator C ermöglicht es, durch diese Anordnung einen elektronischen Verstärker bereitzustellen, bei welchem anhand der Ladungsübertragungen das Sensorsignal in der Form einer zur Sensorkapazität CS proportionalen elektrischen Spannung erzeugt wird. In anderen Worten weist die Sensorkontrollanordnung 170 die Anordnung aus dem Übertragungselement 170.1 und dem Verstärkungsmittel 170.2 auf, um das Sensorsignal mit einer Verstärkung bereitzustellen. Dies bedeutet, dass das Sensorsignal abhängig ist von, und vorzugsweise proportional ist zu, einer Spannung U1 an einem ersten Anschluss 170.A der Sensorkontrollanordnung 170 (bzw. an dem ersten Eingang des Operationsverstärkers 170.1), verstärkt durch einen Verstärkungsfaktor. Der Verstärkungsfaktor kann abhängig sein von, und vorzugsweise proportional sein zu, einem Verhältnis der Sensorkapazität CS zur Kapazität Cmess des Kondensators C. Die Spannung U1 (das Ausgangssignal) am Anschluss 170.A kann wiederrum durch die Nutzung des Spannungsfolgers bzw. einer direkten Gegenkopplung dem Ansteuerungssignal in der Form einer Spannung U0 am Anschluss 170.C im Wesentlichen entsprechen. Somit ergibt sich folgender Zusammenhang für das Sensorsignal, welches als Spannung U2 am Anschluss 170.B der Sensorkontrollanordnung 170 vorliegen kann:

$$U2 = U0 * (1 + CS/Cmess)$$

Es ist erkennbar, dass das Sensorsignal U2 in Abhängigkeit von der veränderlichen Sensorkapazität CS und der Kapazität Cmess verstärkt ist, d. h. als verstärkte Spannung U0 erzeugt wird. Folglich kann das Sensorsignal zur Ermittlung der Sensorkapazität CS dienen. Um die dargestellte Linearität zwischen dem Sensorsignal und der Sensorkapazität CS zu ermöglichen, wird der Widerstand R des Verstärkungsmittels 170.2 möglichst groß gegenüber $(1/(2*\pi*f0*CSmax))$ gewählt, wobei hier f0 die Arbeitsfrequenz, also insbesondere die (mittlere) Frequenz des Ansteuerungssignals, und CSmax der maximal vorgesehene Wert der Sensorkapazität CS ist. Dabei kann die Kapazität Cmess ggf. identisch zur maximalen Sensorkapazität gewählt werden. Die Einstellung von Cmess ermöglicht folglich auch die Einstellung eines Dynamikumfangs bei der Auswertung des Sensorelements 20. Darüber hinaus wird durch die Anordnung aus dem Übertragungselement 170.1 und dem Verstärkungsmittel 170.2 in Zusammenwirkung mit der Sensorkapazität CS ein Filterverhalten (insbesondere Bandpass-Verhalten) bereitgestellt, welches an die Arbeitsfrequenz angepasst sein kann.

Die maximale veränderliche Sensorkapazität ist bspw. die Kapazität (der Kapazitätswert), welche die Sensorkapazität CS bei der Aktivierungshandlung maximal annehmen kann.

Ebenfalls ist es denkbar, dass das Verstärkungsmittel 170.2 als wenigstens ein Filterelement 140.2 einen Kondensator C und/oder einen Widerstand R aufweist, wobei der Kondensator C (bzw. die Kapazität Cmess des Kondensators C) und/oder der Widerstand R an eine maximale veränderliche Sensorkapazität CS angepasst ist. Bevorzugt kann dabei die Kapazität Cmess des Kondensators C der maximalen veränderlichen Sensorkapazität entsprechen. Der Kondensator C kann zur Gegenkopplung bei dem Übertragungselement 170.1 (insbesondere Operationsverstärker 170.1) der Sensorkontrollanordnung 170 ausgebildet sein, und somit vorzugsweise einen Rückkopplungskondensator C ausbilden. Über den Kondensator C kann der Ausgang des Übertragungselements 170.1 und insbesondere der Ausgang 170.B, an welchem das Sensorsignal anliegt, auf einen Eingang des Übertragungselements 170.1 zurückgeführt werden. Zudem kann dieser Eingang mit dem Anschluss 170.A direkt verbunden sein, an welchem das Sensorelement 20 (ggf. über ein Schaltelement 180) angeschlossen ist, und somit das Ausgangssignal bzw. eine elektrische Spannung des Sensorelements 20 anliegt. Auf diese Weise kann das Ausgangssignal über eine direkte Gegenkopplung entsprechend dem Ansteuerungssignal erzeugt werden (diesem folgen). Zudem kann auf diese Weise das Ansteuerungssignal bzw. das Ausgangssignal abhängig von den (durch das Ausgangssignal initiierten) Ladungsübertragungen am Sensorelement 20 verstärkt (mit einem von der Sensorkapazität abhängigen Verstärkungsfaktor) werden, und sodann als das Sensorsignal verstärkt am Anschluss 170.B ausgegeben werden.

Für die Auswertung des für die Erfassung spezifischen Parameters und insbesondere der veränderlichen Sensorkapazität CS ist entsprechend den obigen Ausführungen die Ladungsübertragung vom Sensorelement 20 (bzw. des weiteren Sensorelements 20') an die Sensorkontrollanordnung 170 vorgesehen, um diese Ladungsübertragung anhand des Sensorsignals durch eine Auswerteanordnung 200 auszuwerten. Dabei wird zur wiederholten Ermittlung wiederholt eine Ladungsübertragung vom Sensorelement 20 an die Sensorkontrollanordnung 170 durchgeführt, um abhängig von der Menge der dabei übertragenen Ladung eine Speicheranordnung 250, vorzugsweise einen Integrator 250, der Auswerteanordnung 200 aufzuladen. In anderen Worten wird abhängig von, und vorzugsweise proportional zu, dem Sensorsignal die Speicheranordnung 250 aufgeladen. Auf diese Weise kann die durch die Speicheranordnung 250 gespeicherte elektrische Ladung für die Veränderung der Kapazität CS spezifisch sein. Hierzu kann die Speicheranordnung 250 z. B. mittels eines Speicherkondensators eine Speicherkapazität CL bereitstellen.

Die Kontrollvorrichtung 300 kann über einen Anschluss 250.A mit der Speicheranordnung 250 der Auswerteanordnung 200 verschaltet sein, um die durch die Speicheranordnung 250 gespeicherte elektrische Ladung zur Ermittlung des für die Erfassung spezifischen Parameters auszuwerten. Es wird somit hierbei ein Auswertesignal erfasst und ausgewertet, welches spezifisch ist für den Parameter und/oder die gespeicherte elektrische Ladung. Das Auswertesignal kann z. B. eine Spannung über einen Kondensator der Speicheranordnung 250 sein.

Ebenfalls ist in Figur 3 erkennbar, dass die Schildkontrollanordnung 150 und die Sensorkontrollanordnung 170 mit der gleichen Signalgeneratoranordnung 130 und gleichen Filteranordnung 140 über den Kontrollpfad KP elektrisch verschaltet sind. Hierdurch wird ein durch die Signalgeneratoranordnung 130 erzeugtes und/oder durch die Filteranordnung 140 gefiltertes elektrisches Signal (das Ansteuerungssignal) am Kontrollpfad KP sowohl zur Ansteuerung des Sensorelements 20 als auch des Schildelements 160 genutzt, vorzugsweise mit einer im Wesentlichen identischen Signalform des Signals, bevorzugt einer zumindest annähernden Sinusform, sodass eine elektrische Potentialdifferenz zwischen dem Sensorelement 20 und dem Schildelement 160 im Betrieb der Anordnung 10 während der Ansteuerung und/oder Erfassung stets minimiert wird. Das Schildelement 160 kann dabei als aktives Schildelement 160 (sogenanntes "Active Shield") zur aktiven Abschirmung des Sensorelements 20 ausgeführt sein, sodass mittels der Schildkontrollanordnung 150 ein elektrisches Potential am Schildelement 160 dem elektrischen Potential an dem Sensorelement 20 aktiv nachgeführt wird. Dies ermöglicht es, eine Abschirmung des Sensorelements 20 von dem Fahrzeug 1 zu verbessern und somit eine Last zu reduzieren, die zwischen dem Sensorelement 20 und dem Fahrzeug 1 vorliegt. Diese Last führt üblicherweise zu einem relativ großen Anteil bei dem Auswertesignal, welches durch die Kontrollvorrichtung 300 ausgewertet wird. Der aufgrund der veränderbaren Sensorkapazität CS variable Anteil des Auswertesignals ist somit reduziert und daher nur erschwert auswertbar. Zur Verbesserung der Auswertung wird optional eine Kompensationsanordnung 230 eingesetzt. Diese zweigt z. B. je nach Amplitude des Auswertesignals einen Teil des elektrischen Stroms von der Speicheranordnung 250 ab. Die Nutzung eines Schildelements 160, welches zur Abschirmung das gleiche Potential aufweist wie das Sensorelement 20, kann die beschriebenen Schwierigkeiten bei der Auswertung weiter reduzieren.

Es kann wiederholt eine Aufladung und Entladung des Sensorelements 20 über den ersten Anschluss 170.A der Sensorkontrollanordnung 170 mittels der Ladungsübertragungen durchgeführt werden. Diese wiederholten Auf- und Entladungen können durch das Ansteuerungssignal (aufgrund einer sich periodisch verändernden Spannungsamplitude des Ansteuerungssignals) gesteuert werden. In Abhängigkeit von den Ladungsübertragungen kann ein elektrisches Sensorsignal über den zweiten Anschluss 170.B der Sensorkontrollanordnung 170 ausgegeben werden. Es ist möglich, dass eine elektrische Filterung des Sensorsignals durchgeführt wird. Entsprechend kann es sich um eine Filterung für den Auswertezweig bei der Übertragung des Sensorsignals an die Speicheranordnung 250 handeln, welche somit keinen Einfluss auf das elektrische Signal der elektrischen Ansteuerung (am Kontrollpfad KP) und damit auf die Aufladung des Sensorelements 20 hat.

Hierzu kann eine Auswertefilteranordnung 210 genutzt werden, um eine Filterung (wie z. B. eine Bandpassfilterung) des elektrischen Sensorsignals durchzuführen. Dies ermöglicht es, dass die Auswertefilteranordnung 210 störende Immissionen aus der Umgebung des Sensorelements 20 herausfiltern kann. Damit kann die Auswertefilteranordnung 210 eine EMV-Filterung von Immissionen bereitstellen. Hierzu weist die Auswertefilteranordnung 210 z. B. einen komplexen Widerstand und zusätzlich Filterelemente auf. Es ist dabei denkbar, dass die beschriebene Form (z. B. Sinusform) des elektrischen Signals der elektrischen Ansteuerung am Kontrollpfad KP (d. h. des Ansteuerungssignals) die elektrische Spannung des Signals betrifft. Die Spannung des Sensorsignals am Anschluss 170.B kann die gleiche Form aufweisen, jedoch ggf. eine (proportional zur Sensorkapazität CS) verstärkte Amplitude. Allerdings kommt es bei der Auswertung ggf. auf die Ladungsübertragung und damit den elektrischen Strom bei der Übertragung des Sensorsignals an die Speicheranordnung 250 an. Daher kann die Auswertefilteranordnung 210 einen Transkonduktanzwandler aufweisen, um eine Transkonduktanzwandlung des Sensorsignals am Anschluss 170.B durchzuführen. Unter einer solchen Transkonduktanzwandlung wird verstanden, dass eine Spannung in einen dazu proportionalen Strom umgewandelt wird. In anderen Worten kann die Auswertefilteranordnung 210 dazu ausgebildet und/oder derart in der Auswerteanordnung 200 verschaltet sein, dass aus der Spannung des elektrischen Signals (Sensorsignals) am zweiten Anschluss 170.B mit der beschriebenen Form (z. B. Sinusform) ein elektrischer Strom mit dieser Form am Ausgang 210.A der Auswertefilteranordnung 210 gebildet wird. Der Transkonduktanzwandler ist z. B. als ein Transkonduktanzverstärker (unter Verwendung eines Operationsverstärkers) ausgebildet, stellt bevorzugt jedoch die Transkonduktanzwandlung ohne Operationsverstärker aufgrund der Verschaltung mit der Speicheranordnung 250 bereit. Dies wird z. B. durch die Schaltungskonfiguration der Auswertefilteranordnung 210 in Reihe zur Speicheranordnung 250 möglich. Ferner können die nachgeschalteten Komponenten 220, 250 niederohmig sein, und/oder die Speicheranordnung 250 z. B. am Eingang 250.B den invertierenden Eingang (-) eines Verstärkungselements, und insbesondere Operationsverstärkers aufweisen. Das Verstärkungselement der Speicheranordnung 250 kann dazu ausgeführt sein, dass bei einer auftretenden Spannung am Eingang 250.B unverzüglich Gegenmaßnahmen eingeleitet werden. Hierzu kann ein Operationsverstärker die Differenzspannung seiner Eingänge mittels einer Rückkopplung auf Null regeln. Diese Vorkehrungen und/oder die Anordnung der Auswerteanordnung 200 seriell zur Speicheranordnung 250 bewirken, dass nahezu keine Spannung am Eingang 250.B bzw. Ausgang 210.A abfällt. In anderen Worten liegt an diesem Punkt (am Eingang 250.B bzw. am Ausgang 210.A, wenn diese miteinander z. B. über einen Schalter der Gleichrichteranordnung 220 verbunden sind) nahezu ein Massepotential vor, sodass dieser Punkt als ein virtueller Nullpunkt angesehen werden kann.

Der in Figur 3 gezeigte Block 220 kann einen oder mehrere Gleichrichter betreffen, und damit eine Gleichrichteranordnung 220. Die Gleichrichteranordnung 220 kann ggf. ohne Dioden oder dergleichen auskommen, sodass im Wesentlichen kein (bzw. nahezu kein) Spannungsabfall an der Gleichrichteranordnung 220 erfolgt. Dies kann bspw. dadurch umgesetzt werden, dass die Gleichrichtung mittels wenigstens eines elektronischen Schalters durchgeführt wird, welcher getaktet geschaltet wird. Auf diese Weise kann bei der Herstellung der elektrischen Verbindung des Ausgangs 210.A mit dem Eingang 250.B durch die Gleichrichteranordnung 220 und insbesondere durch den wenigstens einen Schalter ein virtueller Nullpunkt für den Eingang 250.B bzw. Ausgang 210.A bereitgestellt werden (wenn der Schalter geschlossen wird). Wenn hingegen der wenigstens eine Schalter geöffnet wird, kann der Ausgang 210.A der Auswertefilteranordnung 210 auf ein Massepotential 21 gelegt werden. Bspw. verbindet hierzu der Schalter als Wechselschalter den Ausgang 210.A mit dem Massepotential 21. Auf diese Weise kann stets zumindest annähernd ein Massepotential am Ausgang 210.A anliegen, unabhängig von der Schalterstellung des wenigstens einen Schalters bei der Gleichrichteranordnung 220. Damit wird eine Belastung der Auswertefilteranordnung 210 deutlich verringert.

Bei der beschriebenen Gleichrichtung kann es sich um eine "kohärente" Gleichrichtung durch den wenigstens einen Gleichrichter handeln. Darunter wird verstanden, dass der wenigstens eine Gleichrichter jeweils mit einem vorgegebenen Takt das elektrische Signal (Sensorsignal) von der Auswertefilteranordnung 210 an die Speicheranordnung 250 weiterleitet, vorzugsweise phasen-synchronisiert mit der elektrischen Ansteuerung. Dies bewirkt, dass das Sensorsignal kohärent zum Ansteuerungssignal gleichgerichtet wird. Hierzu kann jeder der Gleichrichter wenigstens einen elektronischen Schalter aufweisen. Der Takt kann dabei jeweils derart vorgegeben sein, dass nur positive (oder alternativ negative) Halbwellen einer jeweils vorgegebenen Grundschwingung bzw. Harmonischen des elektrischen Signals (z. B. mit der ersten Harmonischen als die Grundschwingung der Frequenz, welche durch die Auswertefilteranordnung 210 als Mittenfrequenz durchgelassen wird, und ggf. weiteren Harmonischen) weitergeleitet werden. Daher kann der jeweilige Takt mit der Signalgeneratoranordnung 130 synchronisiert sein, um an die Form des elektrischen Signals (Ansteuerungssignals) der elektrischen Ansteuerung angepasst zu sein. Unter Berücksichtigung der Filterung durch die Auswertefilteranordnung 210 wird bei dieser Synchronisation die Phasenverschiebung zwischen Spannung (entsprechend dem elektrischen Signal der elektrischen Ansteuerung am Kontrollpfad KP) und Strom (entsprechend dem Signal am Ausgang 210.A der Auswertefilteranordnung 210) in Betracht gezogen. Ferner kann die Gleichrichtung ggf. auch mit Dioden "inkohärent" erfolgen.

Es ist außerdem möglich, dass die Gleichrichtung in der Form einer Einweggleichrichtung erfolgt, oder dass alternativ sowohl die positive als auch die negative Halbwelle des Sensorsignals zur Ladungsübertragung an die Speicheranordnung 250 genutzt werden.

Darüber hinaus kann es vorgesehen sein, dass eine Frequenz des Sensorsignals (als periodisches Signal) abhängig ist von einer Arbeitsfrequenz, d. h. der Frequenz des Ansteuerungssignals am Anschluss 170.C (bzw. am Ausgang der Filteranordnung 140). Somit kann für die gesamte Anordnung 10 eine einzige Arbeitsfrequenz sowohl für die Ansteuerung als auch für die Auswertung des Sensorelements 20 genutzt werden, um die Ansteuerung und Auswertung des Sensorelements 20 mit einem vorgegebenen Arbeitsfrequenzbereich durchzuführen. Hierzu wird eine Filterung bei der elektrischen Ansteuerung (durch die Filteranordnung 140) und bei der Auswertung (durch die Auswertefilteranordnung 210) genutzt, wobei die Filterung an die Arbeitsfrequenz angepasst ist (z. B. einen Tief- und/oder Bandpass zum Durchlassen des Arbeitsfrequenzbereiches ausbildet). Dies ermöglicht eine optimale Auswertung hinsichtlich EMV-Bedingungen (bei Emissionen) und störenden Einwirkungen (bei Immissionen).

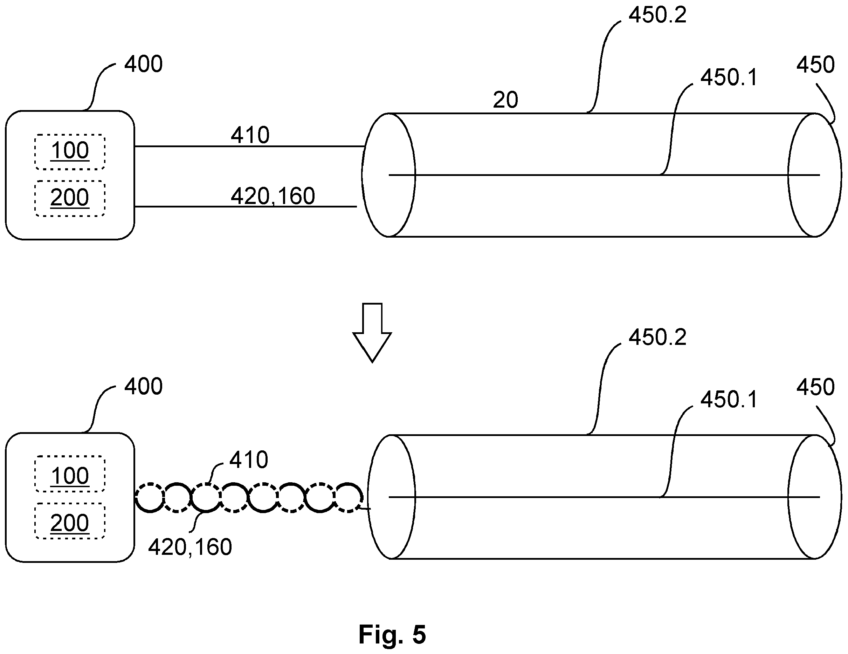

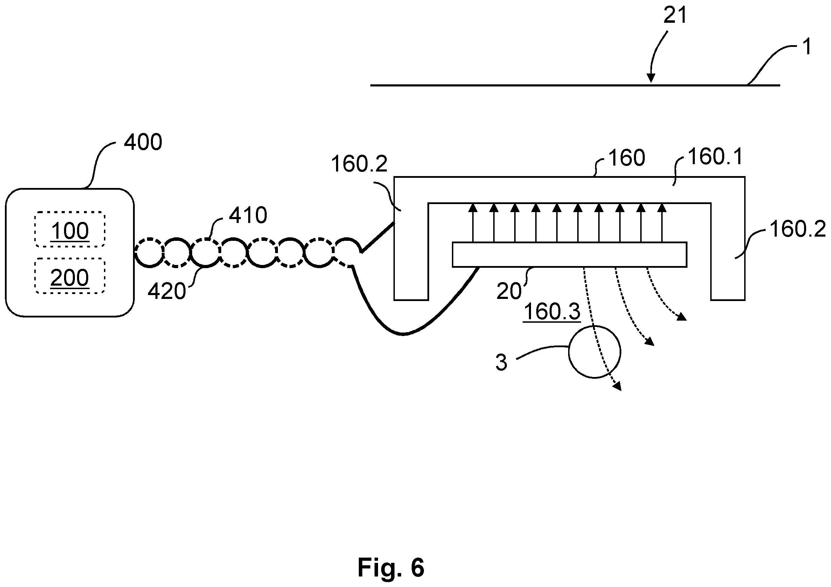

Figur 5 zeigt eine mögliche Ausgestaltung der erfindungsgemäßen Anordnung 10, wenn diese mit einem langgestreckten Sensorelement 20 genutzt wird. Eine solche Ausbildung findet bspw. Anwendung, wenn das Sensorelement 20 in einem Stoßfänger 1.1 an einer Front- oder Heckseite des Fahrzeuges 1 eingesetzt werden soll. Hierdurch ist es möglich, eine Bewegung des Aktivierungsmittels 3 unterhalb des Stoßfängers 1.1 als Aktivierungshandlung zu erfassen, wie es auch in Figur 6 verdeutlicht wird. Anders als bei einer Ausbildung des Sensorelements 20 als Leiterbahn einer Leiterplatte, wie es bei der Anordnung im Türgriff 1.5 zur Bereitstellung eines räumlich eher begrenzten Detektionsbereichs sinnvoll sein kann, wird bei einem größeren Detektionsbereich ein separates Sensorelement 20 mit der Leiterplatte verbunden. Hierzu kann z. B. ein Sensorelementanschluss 180.A der Leiterplatte genutzt werden, welcher eine elektrische Verbindung mit dem Schaltelement 180 bereitstellt. Dieses kann wiederum die elektrische Verbindung über die Sensorkontrollanordnung 170 und den Kontrollpfad KP sowie der Filteranordnung 140 zur Signalgeneratoranordnung 130 (zur Aufladung) bzw. über die Auswertefilteranordnung 210 und die Gleichrichteranordnung 220 zur Speicheranordnung 250 (zur Auswertung) bereitstellen. Die genannten Komponenten 170, 140, 130, 210, 220, 250 können ebenfalls an der Leiterplatte angeordnet sein.

Die Leiterplatte mit den Komponenten, in anderen Worten die Kontrollanordnung 100 und/oder die Auswerteanordnung 200, kann als ein gemeinsames Bauteil aufgefasst werden, welches nachfolgend als Sensorschaltanordnung 400 bezeichnet wird. Es ist optional möglich, dass diese Sensorschaltanordnung 400 als einzeln handhabbares und am Fahrzeug montierbares Teil ausgeführt ist. Die Sensorschaltanordnung 400 kann zur Montage der erfindungsgemäßen Anordnung 10 über wenigstens eine Sensorzuleitung 410 mit dem Sensorelement 20 und ggf. mit wenigstens einem weiteren Sensorelement 20' elektrisch verbunden sein. Das wenigstens eine weitere Sensorelement 20' kann dabei ggf. über wenigstens eine weitere Sensorzuleitung 410 mit der Sensorschaltanordnung 400 verbunden sein. Optional ist es zudem möglich, dass die Sensorschaltanordnung 400 über eine Schildleitung 420, insbesondere Schildzuleitung 420, mit wenigstens einem Schildelement 160 oder weiteren Schildelement elektrisch verbunden ist, oder dass die Schildleitung 420 das Schildelement 160 (d. h. ggf. auch ein weiteres Schildelement) bildet.

Als eine beispielhafte Ausgestaltung für die erfindungsgemäße Anordnung 10 ist ein Koaxialkabel 450 in Figur 5 schematisch gezeigt, deren Außenleiter 450.2 als Sensorelement 20 genutzt wird. In anderen Worten bildet der Schirm 450.2 des Koaxialkabels 450 das Sensorelement 20. Hierzu kann über den Anschluss 180.A der Sensorschaltanordnung 400 die Sensorzuleitung 410 mit dem Außenleiter 450.2 elektrisch verbunden werden. Der Anschluss 180.A überträgt dabei das elektrische Signal der elektrischen Ansteuerung, welches von der Signalgeneratoranordnung 130 und/oder der Filteranordnung 140 vorgegeben (also erzeugt und ggf. gefiltert) und ferner durch eine Sensorkontrollanordnung 170 am Anschluss 180.A ausgegeben werden kann. In gleicher Weise kann über einen Schildelementanschluss 150.A der Sensorschaltanordnung 400 eine Schildzuleitung 420 mit einem Schildelement 160 verbunden sein (siehe Figur 6) oder die mit dem Schildelementanschluss 150.A verbundene Schildleitung 420 selbst das Schildelement 160 (oder ggf. auch ein weiteres Schildelement) bilden. Insbesondere im letzteren und in Figur 5 gezeigten Fall kann es sinnvoll sein, wenn das Schildelement 160 als passives Schildelement 160 betrieben wird. Der Innenleiter 450.1 (d. h. die Seele) des Koaxialkabels 450 kann ggf. unverbunden bleiben.

Bei einem Betrieb als passives Schildelement 160 wird das Schildelement 160 im Betrieb (stets bzw. während des Auf- und/oder Entladens des Sensorelements 20) mit einem vorgegebenen konstanten elektrischen Potential über den Schildelementanschluss 150.A verbunden. Das elektrische Potential des Schildelements 160 kann dabei einem Massepotential 21 entsprechen oder ein davon abweichendes Potential sein. Im Gegensatz hierzu kann beim Betrieb als aktives Schildelement 160 das elektrische Potential des Schildelements 160 in Abhängigkeit vom elektrischen Potential des Sensorelements 20 nachgeführt und variiert werden.

Es ist über einen Pfeil in Figur 5 verdeutlicht, dass zur Montage der erfindungsgemäßen Anordnung 10 am Fahrzeug 1 eine Verdrillung der Zuleitungen 410, 420 durchgeführt werden kann. Zunächst kann dabei das Schildelement 160 in der Form einer Schildleitung 420 als langestreckte Schildelektrode 160 parallel zur Sensorzuleitung 410 verlaufen. Die Verdrillung kann z. B. durch ein Gegeneinanderverwinden und ein schraubenförmiges Umeinanderwickeln der Sensorzuleitung 410 mit der Schildleitung 420 erfolgen. Die verdrillten Zuleitungen 410, 420 sind mit einer gestrichelten und durchgehenden Linie hervorgehoben. Auf diese Weise kann die Empfindlichkeit gegenüber äußere elektromagnetische Störeinflüsse auf die Zuleitungen 410, 420 reduziert werden. Anschließend kann zur Montage die Sensorzuleitung 410 mit dem Außenleiter 450.2 elektrisch verbunden werden, sodass der Außenleiter 450.2 das Sensorelement 20 bildet. Die Schildleitung 420 sowie die Seele 450.1 des Koaxialkabels 450 bleiben ggf. unverbunden. Alternativ wird die Schildleitung 420 mit der Seele 450.1 elektrisch verbunden. Bei dieser Konfiguration ist es vorteilhaft, wenn das Schildelement 160 als passives Schildelement 160 verwendet wird.

Alternativ ist auch ein Betrieb des Schildelements 160 bzw. der Schildleitung 420 als aktives Schildelement 160 sinnvoll. Hierzu wird ggf. eine andere Verschaltung am Koaxialkabel 450 gewählt. Dabei kann die Sensorzuleitung 410 mit der Seele 450.1 (also dem Innenleiter 450.1) des Koaxialkabels 450 elektrisch verbunden werden, sodass die Seele 450.1 als Sensorzuleitung dient. Die Schildleitung 420, in diesem Fall ggf. als Schildzuleitung 420, kann mit dem Außenleiter 450.2 (d. h. mit der Abschirmung) des Koaxialkabels 450 elektrisch verbunden werden, sodass der Außenleiter 450.2 das aktive Schildelement 160 bildet. Das Koaxialkabel 450 mit der Seele 450.1 kann dabei als Zuleitung zum Sensorelement 20 dienen, welches dann allerdings separat vom Koaxialkabel 450 ausgeführt ist. Der Außenleiter 450.2 bewirkt als aktives Schildelement 160 eine verbesserte Abschirmung der Sensorzuleitung 410. Die Zuleitung 410, 420 zum Koaxialkabel 450 kann wie zuvor beschrieben verdrillt sein, oder es kann sich um parallel geführte Leitungen handeln.

Ein separates Sensorelement 20, welches z. B. über die zuvor beschriebenen verdrillten Zuleitungen 410, 420 und/oder über das Koaxialkabel 450 mit dem Außenleiter 450.2 als aktives Schildelement 160 und/oder über eine davon abweichende Variante, mit der Sensorschaltanordnung 400 verbunden ist, ist beispielhaft in Figur 6 gezeigt. Das Sensorelement 20 kann z. B. als elektrisch leitfähige Fläche (sogenannte Flachelektrode 20) und/oder als eine elektrisch leitfähige Leitung oder dergleichen ausgebildet sein. Das Sensorelement 20 ist in einer montierten Anordnung (z. B. im Heckbereich) in der Nähe zu weiteren Teilen des Fahrzeuges 1 gezeigt. Schematisch angedeutet ist dabei ein Teil des Fahrzeuges 1, welcher als Massepotential 21 angesehen werden kann. Das Fahrzeug 1 kann eine Last auf das Sensorelement 20 verursachen, welcher durch eine Abschirmung entgegengewirkt werden kann. Es wird dabei durch Pfeile das elektrische Feld verdeutlicht, welches zwischen einem Schildelement 160 und dem Sensorelement 20 auftreten kann (und durch den Betrieb des Schildelements 160 als ein aktives Schildelements 160 möglichst reduziert bzw. eliminiert werden kann), und welches zur Erfassung der Aktivierungshandlung bzw. des Aktivierungsmittels 3 dient.

Besonders vorteilhaft ist dabei die gezeigte Form des (aktiven) Schildelements 160. Die Form ist bspw. eine U-Form, wobei die beiden gegenüberstehenden Seitenteile 160.2 des Schildelements 160 einen seitlichen Bereich und ein Mittenteil 160.1 des Schildelements 160 den Mittenbereich bzw. die Fahrzeugseite abschirmt. Auf diese Weise kann der Detektionsbereich sehr genau durch den offenen Bereich 160.3 des Schildelements 160 zwischen den Seitenteilen 160.2 definiert werden. Das Schildelement 160 kann z. B. dadurch als aktives Schildelement 160 betrieben werden, dass es mit der Schild(zu)leitung 420 bzw. mit einem Außenleiter 450.2 des Koaxialkabels 450 (wenn dieses als Zuleitung verwendet wird) elektrisch verbunden wird. Das Sensorelement 20 kann ferner mit der Sensorzuleitung 410 und/oder mit der Seele 450.1 des Koaxialkabels 450 (wenn dieses als Zuleitung verwendet wird) elektrisch verbunden werden. Alternativ kann die Form auch anders als eine U-Form ausgebildet sein, insbesondere wenn das Schildelement 160 breiter ist als das Sensorelement 20.

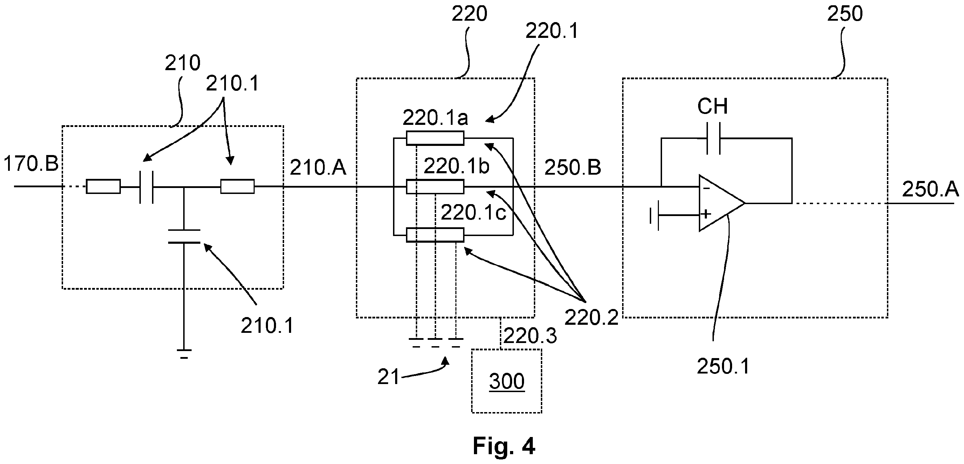

In Figur 4 ist eine Auswertefilteranordnung 210, eine Gleichrichteranordnung 220 und eine Speicheranordnung 250 mit weiteren Einzelheiten gezeigt. Die Auswertefilteranordnung 210 kann zur Filterung des Sensorsignals, welches durch die Sensorkontrollanordnung 170 bevorzugt als ein Spannungssignal bereitgestellt wird, mehrere Filterelemente 210.1 aufweisen. Diese Filterelemente können jeweils z. B. als Widerstand, Spule und/oder Kondensator ausgebildet sein, und somit als RC- und/oder RL-Glied (und/oder als RLC-Glied) ausgeführt sein. Durch die Verschaltung und Auslegung der Filterelemente 210.1 kann ein Tief- und Hochpass-Verhalten der Auswertefilteranordnung 210 eingestellt werden, und damit ein Bandpass-Filter bereitgestellt werden. Dieses Bandpass-Filter ist vorteilhafterweise hinsichtlich seines Durchlassbereiches und/oder der Mittenfrequenz an eine Frequenz der elektrischen Ansteuerung, insbesondere eine Arbeitsfrequenz des Ansteuerungssignals, angepasst. Durch die serielle Verschaltung mit einem virtuellen Nullpunkt 250.B der Speicheranordnung 250 kann sodann das gefilterte Sensorsignal als ein Stromsignal an die Speicheranordnung 250 weitergeleitet werden. Dabei kann das Stromsignal eine Stromstärke aufweisen, welche hinsichtlich der Amplitude und/oder Signalform dem Spannungssignal entspricht. Auf diese Weise kann eine Ladungsübertragung an und damit Aufladung der Speicheranordnung 250 erfolgen.

Um die Ladungsübertragung nur in Richtung der Speicheranordnung 250 zu ermöglichen, kann zwischen der Auswertefilteranordnung 210 und der Speicheranordnung 250 eine Gleichrichteranordnung 220 verschaltet sein. Dabei ist es wünschenswert, dass nur bestimmte Halbwellen des Sensorsignals an die Speicheranordnung 250 weitergeleitet werden, um nur eine Aufladung der Speicheranordnung 250, jedoch keine Entladung durch das Sensorsignal zu bewirken. Die Gleichrichteranordnung 220 kann hierzu wenigstens einen steuerbaren Gleichrichter 220.1, vorzugsweise in der Form eines Synchrongleichrichters oder dergleichen, aufweisen, welcher die Gleichrichtung des Sensorsignals synchronisiert, insbesondere kohärent, zum Ansteuerungssignal durchführt. Es ist daher erforderlich, dass die Signalform des Sensorsignals (insbesondere des gefilterten Sensorsignals und damit des Stromsignals) bekannt ist. Es wird sich dabei zunutze gemacht, dass das Sensorsignal durch die Sensorkontrollanordnung 170 anhand des Ansteuerungssignals erzeugt wird, und somit der Signalform des Ansteuerungssignals entspricht (die Verstärkung gegenüber dem Ansteuerungssignal kann jedoch abhängig sein von der Sensorkapazität CS). Um die Synchronisation zu ermöglichen, kann die Gleichrichteranordnung 220, insbesondere der wenigstens eine Gleichrichter 220.1, daher durch die Kontrollvorrichtung 300 angesteuert werden. Die Kontrollvorrichtung 300 kann wiederum die Signalgeneratoranordnung 130 zur Erzeugung des Ansteuerungssignals ansteuern, sodass der Kontrollvorrichtung 300 die Signalform bekannt ist. Auf diese Weise wird die Gleichrichtung des Sensorsignals "kohärent" ermöglicht.

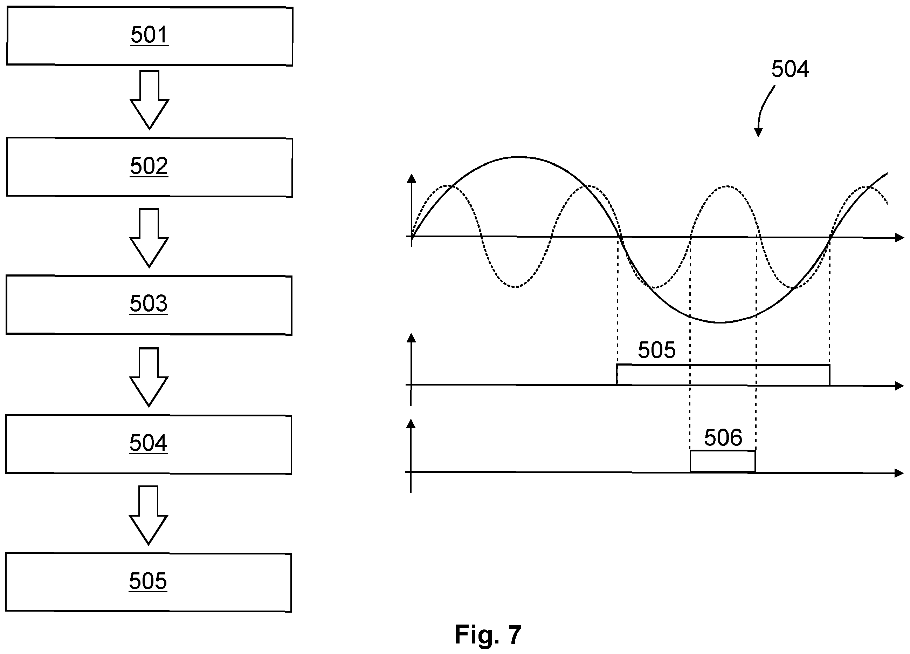

Ferner ist in Figur 4 zu sehen, dass die Gleichrichteranordnung 220 mehrere Gleichrichter 220.1, vorzugsweise Einweggleichrichter oder Vollweggleichrichter, aufweisen kann, welche mit der Kontrollanordnung 100 und/oder Kontrollvorrichtung 300 verschaltet sind. Beispielhaft sind ein erster Gleichrichter 220.1a, ein zweiter Gleichrichter 220.1b sowie ein dritter Gleichrichter 220.1c gezeigt. Diese dienen dazu, mit unterschiedlichen Frequenzen, insbesondere getaktet und/oder kohärent und/oder synchronisiert zum elektrischen Ansteuerungssignal, durch die Kontrollvorrichtung 300 angesteuert zu werden, derart, dass ein erster Gleichrichter 220.1a der Gleichrichter 220.1 nur eine Halbschwingung einer Grundschwingung, insbesondere ersten Harmonischen, des elektrischen Sensorsignals an die Speicheranordnung 250 weiterleitet, und der wenigstens eine weitere Gleichrichter 220.1b, 220.1c die Weiterleitung, insbesondere dieser Halbschwingung, weiterer Harmonischer des elektrischen Sensorsignals an die Speicheranordnung 250 unterdrückt. Auch kann der wenigstens eine weitere Gleichrichter 220.1b, 220.1c ggf. die Weiterleitung der anderen Halbschwingung der weiteren Harmonischen des elektrischen Sensorsignals an die Speicheranordnung 250 zulassen. Dieses Prinzip wird anhand Figur 7 weiter verdeutlicht. Dabei ist die Gleichrichtung 504 durch die Gleichrichteranordnung 220 dargestellt, bei welcher der erste Gleichrichter 220.1a nur bei der negativen Halbwelle gemäß der Grundschwingung schaltet (siehe Schaltsequenz 505) und der zweiter Gleichrichter 220.1b nur bei der positiven Halbwelle gemäß einer weiteren Harmonischen (z. B. 3. Harmonischen) schaltet (siehe Schaltsequenz 506). Auf diese Weise kann eine gleichgerichtete Weiterleitung des Sensorsignals gemäß der Grundschwingung bei gleichzeitiger Störunterdrückung von störenden Frequenzanteilen gemäß den Harmonischen erzielt werden.

Ferner ist in Figur 4 gezeigt, dass die Gleichrichteranordnung 220 wenigstens einen elektronischen Schalter 220.2 aufweist. Insbesondere können dabei die einzelnen Gleichrichter 220.1 jeweils als ein Schalter 220.2 ausgebildet sein oder diesen aufweisen. Der wenigstens eine Schalter 220.2 (gezeigt sind in Figur 4 beispielhaft drei Schalter 220.2) kann jeweils über einen Steuerpfad 220.3 mit der Kontrollvorrichtung 300 verschaltet sein, um für bestimmte Halbschwingungen, insbesondere negative Halbschwingungen, des elektrischen Ansteuerungssignals die Speicheranordnung 250 mit der Übertragungsanordnung 170, 210 zur Übertragung des elektrischen Sensorsignals elektrisch zu verbinden. Hierzu kann jeweils ein Steuersignal des Steuerpfads 220.3 zur Umschaltung des jeweiligen Schalters 220.2 mit dem elektrischen Ansteuerungssignal synchronisiert sein. Das Steuersignal kann dabei z. B. durch die Kontrollvorrichtung 300 ausgegeben werden.

Durch Figur 7 ist ein Verfahren für das Fahrzeug 1 zur Detektion einer Aktivierungshandlung für die Aktivierung einer Funktion am Fahrzeug 1 schematisch visualisiert. Dabei erfolgt gemäß einem ersten Verfahrensschritt 501 ein Erzeugen eines elektrischen Ansteuerungssignals. Anschließend erfolgt gemäß einem zweiten Verfahrensschritt 502 ein Durchführen wiederholter Ladungsübertragungen beim Sensorelement 20 mittels des Ansteuerungssignals. Gemäß einem dritten Verfahrensschritt 503 kann ein Bereitstellen eines elektrischen Sensorsignals anhand der wiederholten Ladungsübertragungen und anhand des Ansteuerungssignals durchgeführt werden. Gemäß einem vierten Verfahrensschritt 504 wird das Sensorsignal gleichgerichtet an eine Speicheranordnung 250 übertragen, um gemäß einem fünften Verfahrensschritt 505 ein Durchführen einer wiederholten Ermittlung wenigstens eines für die Erfassung spezifischen Parameters durchzuführen, insbesondere einer veränderlichen Kapazität, des Sensorelements 20 anhand einer Auswertung bei der Speicheranordnung 250, insbesondere der darin gespeicherten Ladungsmenge, um die Detektion der Aktivierungshandlung anhand der Ladungsübertragungen durchzuführen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

**Bezugszeichenliste**

| 1 | Fahrzeug |
|---|---|
| 1.1 | Stoßfänger |
| 1.2 | Heckbereich |
| 1.3 | Heckklappe |
| 1.4 | Seitenbereich |
| 1.5 | Türgriff |
| 1.6 | Tür |
| 1.7 | Frontbereich |
| 2 | Benutzer |
| 3 | Aktivierungsmittel |
| 5 | Identifikationsgeber |
| 8 | Steuergerät |

| 10 | Anordnung |
|---|---|
| 20 | Sensorelement, Sensorelektrode |
| 20' | weiteres Sensorelement |
| 21 | Massepotential |
| 100 | Kontrollanordnung |
| 130 | Signalgeneratoranordnung, Signalgenerator |
| 130.1 | Digital-Analog-Konverter |
| 140 | Filteranordnung, Aktives Filter, Sinusfilter |
| 140.1 | Operationsverstärker |
| 140.2 | Filterelement |
| 150 | Schildkontrollanordnung |
| 150.A | Schildelementanschluss |
| 150.1 | Operationsverstärker |
| 160 | Schildelement |
| 160.1 | Mittenteil |
| 160.2 | Seitenteil, Schenkel |
| 160.3 | Detektionsbereich, offener Bereich |
| 170 | Sensorkontrollanordnung, Spannungsfolger |
| 170.A | erster Anschluss von 170 |
| 170.B | zweiter Anschluss von 170 |
| 170.1 | Operationsverstärker |
| 170.2 | Filterelement |
| 180 | Schaltelement |
| 180.A | Ausgang von 180, Sensorelementanschluss |
| 200 | Auswerteanordnung |
| 210 | Auswertefilteranordnung |
| 210.A | erster Anschluss bzw. Ausgang von 210 |
| 210.1 | Filterelemente |
| 220 | Gleichrichteranordnung |
| 220.1 | Gleichrichter |
| 220.1a | erster Gleichrichter |
| 220.1b | zweiter Gleichrichter |
| 220.1c | dritter Gleichrichter |
| 220.2 | Schalter |
| 220.3 | Steuerpfad |
| 230 | Kompensationsanordnung |
| 250 | Speicheranordnung, Integrator |
| 250.A | erster Anschluss |
| 250.B | zweiter Anschluss, Eingang |
| 250.1 | Operationsverstärker |
| 300 | Kontrollvorrichtung, Mikrocontroller |
| 400 | Sensorschaltanordnung |
| 410 | Sensorzuleitung |

420    Schildzuleitung

450    Koaxialkabel
450.1  Innenleiter, Seele
450.2  Außenleiter

501    erster Verfahrensschritt
502    zweiter Verfahrensschritt
503    dritter Verfahrensschritt

CL    Speicherkapazität
CS    Sensorkapazität
KP    Kontrollpfad

**Patentansprüche**

1.  Anordnung (10) für ein Fahrzeug (1) zur Detektion einer Aktivierungshandlung für die Aktivierung einer Funktion am Fahrzeug (1), insbesondere zur Detektion einer Aktivierungshandlung in einem Front-, Seiten- und/oder Heckbereich (1.7, 1.4, 1.2) des Fahrzeuges (1) für die Aktivierung einer Öffnung und/oder Entriegelung einer Klappe (1.3, 1.6) am Fahrzeug (1), aufweisend:

    - wenigstens ein Sensorelement (20) zur Erfassung einer Veränderung, insbesondere einer Annäherung durch ein Aktivierungsmittel (3), in einer Umgebung des Sensorelements (20),
    - eine Kontrollanordnung (100), um ein elektrisches Ansteuerungssignal für eine Durchführung wiederholter Ladungsübertragungen beim Sensorelement (20) und für eine kapazitive Sensorauswertung des Sensorelements (20) zu erzeugen,
    - eine Übertragungsanordnung (170, 210) zur Bereitstellung eines elektrischen Sensorsignals anhand der wiederholten Ladungsübertragungen und anhand des Ansteuerungssignals,
    - eine Gleichrichteranordnung (220), welche zur Gleichrichtung des elektrischen Sensorsignals zwischen einer elektrischen Speicheranordnung (250) und der Übertragungsanordnung (170, 210) verschaltet ist, um bei der Sensorauswertung das Sensorsignal gleichgerichtet an die Speicheranordnung (250) zu übertragen, wobei die Gleichrichteranordnung (220) mehrere Gleichrichter (220.1), vorzugsweise Einweggleichrichter oder Vollweggleichrichter, aufweist, welche mit der Kontrollanordnung (100) und/oder Kontrollvorrichtung (300) verschaltet sind, um mit unterschiedlichen Frequenzen, insbesondere getaktet und/oder kohärent und/oder synchronisiert zum elektrischen Ansteuerungssignal, angesteuert zu werden, derart, dass

    - einer (220.1a) der Gleichrichter (220.1) nur eine Halbschwingung des Sensorsignals gemäß einer Grundfrequenz, insbesondere einer ersten Harmonischen, des elektrischen Sensorsignals an die Speicheranordnung (250) weiterleitet, und
    - der wenigstens eine weitere Gleichrichter (220.1b, 220.1c) die Weiterleitung, insbesondere dieser Halbschwingung, des Sensorsignals gemäß weiterer Harmonischer des elektrischen Sensorsignals an die Speicheranordnung (250) unterdrückt,

    - eine Kontrollvorrichtung (300) zur wiederholten Ermittlung wenigstens eines für die Erfassung spezifischen Parameters, insbesondere einer veränderlichen Kapazität (CS), des Sensorelements (20) anhand einer Auswertung bei der Speicheranordnung (250), insbesondere der darin gespeicherten Ladungsmenge, um die Detektion der Aktivierungshandlung anhand der Ladungsübertragungen für die Sensorauswertung durchzuführen.

2.  Anordnung (10) nach Anspruch 1,
    **dadurch gekennzeichnet,**
    **dass** die Gleichrichteranordnung (220) wenigstens einen steuerbaren Gleichrichter (220.1), vorzugsweise Synchrongleichrichter, aufweist, welcher zur Gleichrichtung des Sensorsignals synchronisiert, insbesondere kohärent, zum Ansteuerungssignal ausgeführt ist.

3.  Anordnung (10) nach einem der vorhergehenden Ansprüche,
    **dadurch gekennzeichnet,**
    **dass** die Kontrollanordnung (100) und/oder die Kontrollvorrichtung (300), vorzugsweise ein Mikrocontroller (300), mit der Gleichrichteranordnung (220) verschaltet ist, um die Gleichrichteranordnung (220) in Abhängigkeit von dem elektrischen Ansteuerungssignal und insbesondere einer Phase des elektrischen Ansteuerungssignals anzusteuern, sodass die Gleichrichtung kohärent zum elektrischen Ansteuerungssignal und/oder synchronisiert zur elektrischen Ansteuerung des Sensorelements (20) erfolgt.

4.  Anordnung (10) nach einem der vorhergehenden Ansprüche,
    **dadurch gekennzeichnet,**
    **dass** die Gleichrichteranordnung (220) wenigstens einen elektronischen Schalter (220.2) aufweist, welcher jeweils über einen Steuerpfad (220.3) mit der Kontrollanordnung (100) und/oder Kontrollvorrichtung (300) verschaltet ist, um für bestimmte Halbschwingungen, insbesondere negative Halbschwingungen, des elektrischen Ansteuerungssignals die Speicheranordnung (250) mit der Übertragungsanordnung (170, 210) zur Übertragung des elektrischen Sensorsignals elektrisch zu verbinden, wobei ein Steuersignal des Steuerpfads (220.3) zur Umschaltung des Schalters (220.2) mit dem elektrischen Ansteuerungssignal synchronisiert ist.

5. Anordnung (10) nach einem der vorhergehenden Ansprüche,
**dadurch gekennzeichnet,**
**dass** die Gleichrichteranordnung (220) mehrere, vorzugsweise wenigstens zwei oder wenigstens drei oder wenigstens vier, elektronische Schalter (220.2) aufweist, welche durch die Kontrollanordnung (100) und/oder Kontrollvorrichtung (300) mit unterschiedlichen Frequenzen zur Unterdrückung von Harmonischen des elektrischen Sensorsignals angesteuert werden, um wenigstens eine, insbesondere zweite und/oder dritte und/oder vierte, Harmonische des elektrischen Sensorsignals abzuschwächen.

6. Anordnung (10) nach einem der vorhergehenden Ansprüche,
**dadurch gekennzeichnet,**
**dass** die Gleichrichteranordnung (220) dazu ausgebildet ist, durch wiederholte Umschaltungen nur einen Ladungstransport durch das elektrische Sensorsignal in Richtung der Speicheranordnung (250) an die Speicheranordnung (250) weiterzuleiten, und vorzugsweise nur bei dieser Weiterleitung einen virtuellen Nullpunkt (250.B) der Speicheranordnung (250) mit der Übertragungsanordnung (170, 210) zu verbinden, und vorzugsweise andernfalls die Übertragungsanordnung (170, 210) mit einem Massepotential (21) zu verbinden.

7. Anordnung (10) nach einem der vorhergehenden Ansprüche,
**dadurch gekennzeichnet,**
**dass** eine Auswertefilteranordnung (210) der Übertragungsanordnung (170, 210) vorgesehen ist, um das elektrische Sensorsignal für einen Ladungstransport an die Speicheranordnung (250) gefiltert, insbesondere bandpassgefiltert, und vorzugsweise als sinusartiges Stromsignal, bereitzustellen.

8. Anordnung (10) nach einem der vorhergehenden Ansprüche,
**dadurch gekennzeichnet,**
**dass** eine Sensorkontrollanordnung (170) der Übertragungsanordnung (170, 210) vorgesehen und dazu ausgeführt ist, anhand der Ladungsübertragungen und anhand des Ansteuerungssignals ein elektrisches Spannungssignal mit einer bestimmten Frequenz und/oder Signalform, vorzugsweise sinusartigen Form, an einem Ausgang (170.B) auszugeben, und eine Auswertefilteranordnung (210) der Übertragungsanordnung (170, 210) dazu ausgeführt ist, für die Sensorauswertung das Spannungssignal in ein elektrisches Stromsignal mit der im Wesentlichen gleichen Signalform und/oder Frequenz umzuwandeln, sodass sich das Sensorsignal als das elektrische Stromsignal durch eine Transkonduktanzwandlung ergibt.

9. Anordnung (10) nach einem der vorhergehenden Ansprüche,
**dadurch gekennzeichnet,**
**dass** das Sensorelement (20) als eine Sensorelektrode (20) ausgebildet ist, um den für die Erfassung spezifischen Parameter als eine veränderliche Kapazität (CS) bereitzustellen, wobei die Veränderung der Kapazität (CS) für die Veränderung in der Umgebung spezifisch ist, wobei die Anordnung (10) dazu ausgeführt ist, zur wiederholten Ermittlung für die Sensorauswertung wiederholt die Ladungsübertragungen zwischen dem Sensorelement (20) und der Übertragungsanordnung (170, 210) durchzuführen, und davon abhängig das Sensorsignal an die Speicheranordnung (250), insbesondere einen Integrator (250), auszugeben, sodass die durch die Speicheranordnung (250) gespeicherte elektrische Ladung für die Veränderung der Kapazität (CS) spezifisch ist.

10. Anordnung (10) nach einem der vorhergehenden Ansprüche,
**dadurch gekennzeichnet,**
**dass** die Kontrollvorrichtung (300) mit der Speicheranordnung (250) verschaltet ist, um eine durch die Speicheranordnung (250) gespeicherte elektrische Ladung zur Ermittlung des für die Erfassung spezifischen Parameters auszuwerten, vorzugsweise durch eine Analog-Digital-Umwandlung einer Spannung bei der Speicheranordnung (250).

11. Anordnung (10) nach einem der vorhergehenden Ansprüche,
**dadurch gekennzeichnet,**
**dass** die Anordnung (10) als kapazitive Sensoranordnung zumindest teilweise in einem Stoßfänger (1.1) des Fahrzeuges (1) integriert ist, um den Heckbereich (1.2) des Fahrzeuges (1) zu überwachen, und um als die Funktion am Fahrzeug (1) die Heckklappe (1.3) des Fahrzeuges (1) zu öffnen, insbesondere um eine Ausgabe eines Öffnungssignals und/oder eine Authentifizierungsprüfung zu initiieren.

12. System aufweisend:

- eine Anordnung (10) gemäß einem der vorhergehenden Ansprüche,
- die Kontrollvorrichtung (300) zur Ausgabe eines Aktivierungssignals im Falle der Detektion der Aktivierungshandlung,
- ein Steuergerät (8), welches mit der Kontrollvorrichtung (300) verbunden ist, um bei Empfang des Aktivierungssignals die Funktion am Fahrzeug (1) auszuführen.

13. Verfahren für ein Fahrzeug (1) zur Detektion einer Aktivierungshandlung für die Aktivierung einer Funktion am Fahrzeug (1), insbesondere in einem Front-, Seiten- und/oder Heckbereich (1.2, 1.4, 1.7) des Fahrzeuges (1) für die Aktivierung einer Öffnung und/oder Entriegelung einer Klappe (1.3, 1.6) am Fahrzeug (1), wobei eine Anordnung (10) nach einem der Ansprüche 1 bis 11 betrieben wird, wobei die nachfolgenden Schritte durchgeführt werden:

- Erzeugen eines elektrischen Ansteuerungssignals,
- Durchführen wiederholter Ladungsübertragungen beim Sensorelement (20) mittels des Ansteuerungssignals,
- Bereitstellen eines elektrischen Sensorsignals anhand der wiederholten Ladungsübertragungen und anhand des Ansteuerungssignals,
- Durchführen einer Übertragung des Sensorsignals gleichgerichtet an eine Speicheranordnung (250),
- Durchführen einer wiederholten Ermittlung wenigstens eines für die Erfassung spezifischen Parameters, insbesondere einer veränderlichen Kapazität (CS), des Sensorelements (20) anhand einer Auswertung bei der Speicheranordnung (250), insbesondere der darin gespeicherten Ladungsmenge, um die Detektion der Aktivierungshandlung anhand der Ladungsübertragungen durchzuführen.

**Claims**

1. Arrangement (10) for a vehicle (1) for detecting an activation action for activating a function on the vehicle (1), in particular for detecting an activation action in a front, side and/or rear area (1.7, 1.4, 1.2) of the vehicle (1) for activating an opening and/or unlocking of a flap (1.3, 1.6) on the vehicle (1), comprising:

- at least one sensor element (20) for detecting a change, in particular an approach by an activation means (3), in a vicinity of the sensor element (20),
- a control arrangement (100) for generating an electrical drive signal for performing repetitive charge transmissions at the sensor element (20) and for capacitive sensing evaluation of the sensor element (20),
- a transmission arrangement (170, 210) for providing an electrical sensor signal based on the repeated charge transmissions and based on the drive signal,
- a rectifier arrangement (220) which is connected between an electrical storage arrangement (250) and the transmission arrangement (170, 210) for rectifying the electrical sensor signal, in order to transmit the sensor signal rectified to the storage arrangement (250) during sensor evaluation, the rectifier arrangement (220) having a plurality of rectifiers (220.1), preferably half-wave rectifiers or full-wave rectifiers, which are connected to the control arrangement (100) and/or control device (300) in order to be driven at different frequencies, in particular clocked and/or coherently and/or synchronized with the electrical drive signal, in such a way that

- one (220.1a) of the rectifiers (220.1) transmits only a half-oscillation of the sensor signal according to a fundamental frequency, in particular a first harmonic, of the electrical sensor signal to the storage arrangement (250), and
- the at least one further rectifier (220.1b, 220.1c) suppresses the forwarding, in particular of this half-oscillation, of the sensor signal in accordance with further harmonics of the electrical sensor signal to the storage arrangement (250),

- a control device (300) for repeatedly determining at least one parameter specific to the detection, in particular a variable capacitance (CS), of the sensor element (20) on the basis of an evaluation at the storage arrangement (250), in particular the amount of charge stored therein, in order to carry out the detection of the activation action on the basis of the charge transmissions for the sensor evaluation.

2. Arrangement (10) according to claim 1, **characterized in that** the rectifier arrangement (220) has at least one controllable rectifier (220.1), preferably synchronous rectifier, which is designed to be synchronized, in particular coherent, with the drive signal for rectifying the sensor signal.

3. Arrangement (10) according to any one of the preceding claims, **characterized in that** the control arrangement (100) and/or the control device (300), preferably a microcontroller (300), is connected to the rectifier arrangement (220) in order to drive the rectifier arrangement (220) as a function of the electrical drive signal and, in particular, of a phase of the electrical drive signal, so that the rectification takes place coherently with the electrical drive signal and/or synchronized with the electrical drive of the sensor element (20).

4. Arrangement (10) according to any one of the preceding claims,
**characterized in that**
the rectifier arrangement (220) has at least one electronic switch (220.2) which is connected in each case via a control path (220.3) to the control arrangement (100) and/or control device (300) in order to electrically connect the storage arrangement (250) to the transmission arrangement (170, 210) for transmitting the electrical sensor signal for certain half oscillations, in particular negative half oscillations, of the electrical drive signal, a control signal of the control path (220.3) for switching the switch (220.2) being synchronized with the electrical drive signal.

5. Arrangement (10) according to any one of the preceding claims,
**characterized in that**
the rectifier arrangement (220) has a plurality of, preferably at least two or at least three or at least four, electronic switches (220.2) which are driven by the control arrangement (100) and/or control device (300) at different frequencies for suppressing harmonics of the electrical sensor signal in order to attenuate at least one, in particular second and/or third and/or fourth, harmonic of the electrical sensor signal.

6. Arrangement (10) according to any one of the preceding claims,
**characterized in that**
the rectifier arrangement (220) is designed to forward only one charge transport by the electrical sensor signal in the direction of the storage arrangement (250) to the storage arrangement (250) by repeated switching, and preferably to connect a virtual zero point (250.B) of the storage arrangement (250) to the transmission arrangement (170, 210) only during this forwarding, and preferably otherwise to connect the transmission arrangement (170, 210) to a ground potential (21).

7. Arrangement (10) according to any one of the preceding claims,
**characterized in that**
an evaluation filter arrangement (210) of the transmission arrangement (170, 210) is provided in order to provide the electrical sensor signal for a charge transmission to the storage arrangement (250) filtered, in particular bandpass-filtered, and preferably as a sinusoidal current signal.

8. Arrangement (10) according to any one of the preceding claims,
**characterized in that**
a sensor control arrangement (170) of the transmission arrangement (170, 210) is provided and is designed to output an electrical voltage signal with a specific frequency and/or signal form, preferably sinusoidal form, at an output (170.B), and an evaluation filter arrangement (210) of the transmission arrangement (170, 210) is designed to convert the voltage signal into an electrical current signal with essentially the same signal form and/or frequency for the sensor evaluation, so that the sensor signal results as the electrical current signal by means of a transconductance conversion.

9. Arrangement (10) according to any one of the preceding claims,
**characterized in that**
the sensor element (20) is designed as a sensor electrode (20) in order to provide the parameter specific to the detection as a variable capacitance (CS), the variation in the capacitance (CS) being specific to the variation in the environment, the arrangement (10) being designed for this purpose to repeatedly perform the charge transmissions between the sensor element (20) and the transmission arrangement (170, 210) for the repeated determination for the sensor evaluation, and to output the sensor signal to the storage arrangement (250), in particular an integrator (250), depending thereon, so that the electrical charge stored by the storage arrangement (250) is specific for the change in the capacitance (CS).

10. Arrangement (10) according to any one of the preceding claims,
**characterized in that**
the control device (300) is connected to the storage arrangement (250) for evaluating an electric charge stored by the storage arrangement (250) for determining the parameter specific for the detection, preferably by an analog-to-digital conversion of a voltage at the storage arrangement (250).

11. Arrangement (10) according to any one of the preceding claims,
**characterized in that**
the arrangement (10) is integrated as a capacitive sensor arrangement at least partially in a bumper (1.1) of the vehicle (1) in order to monitor the rear region (1.2) of the vehicle (1) and, as the function on the vehicle (1), to open the tailgate (1.3) of the vehicle (1), in particular in order to initiate an output of an opening signal and/or an authentication check.

12. System comprising:

- an arrangement (10) according to any one of the preceding claims,
- the control device (300) for outputting an activation signal in case of detection of the activation action,

- a control unit (8) connected to the control device (300) to perform the function on the vehicle (1) upon receipt of the activation signal.

**13.** Method for a vehicle (1) for the detection of an activation action for the activation of a function on the vehicle (1), in particular in a front, side and/or rear area (1.2, 1.4, 1.7) of the vehicle (1) for the activation of an opening and/or unlocking of a flap (1.3, 1.6) on the vehicle (1), wherein an arrangement (10) according to one of the claims 1 to 11 is operated, wherein the following steps are carried out:

- Generating an electrical drive signal,
- Performing repeated charge transmissions at the sensor element (20) by means of the drive signal,
- Providing an electrical sensor signal based on the repeated charge transmissions and based on the drive signal,
- Performing a transmission of the sensor signal rectified to a storage arrangement (250),
- Carrying out a repeated determination of at least one parameter specific to the detection, in particular a variable capacitance (CS), of the sensor element (20) on the basis of an evaluation at the storage arrangement (250), in particular of the amount of charge stored therein, in order to carry out the detection of the activation action on the basis of the charge transmissions.

**Revendications**

**1.** Dispositif (10) pour un véhicule (1) pour la détection d'une action d'activation pour l'activation d'une fonction sur le véhicule (1), présentant en particulier pour la détection d'une action d'activation dans une zone avant, latérale et/ou arrière (1.7, 1.4, 1.2) du véhicule (1) pour l'activation d'une ouverture et/ou d'un déverrouillage d'un volet (1.3, 1.6) sur le véhicule (1) :

- au moins un élément de détection (20) pour détecter un changement, en particulier une approche par un moyen d'activation (3), dans un environnement de l'élément de détection (20),
- un arrangement de contrôle (100) pour générer un signal de commande électrique pour une exécution de transferts de charge répétés sur l'élément de détection (20) et pour une évaluation de détection capacitive de l'élément de détection (20),
- un dispositif de transmission (170, 210) pour fournir un signal de capteur électrique sur la base des transferts de charge répétés et sur la base du signal de commande,
- un dispositif redresseur (220) qui est connecté entre un dispositif de stockage électrique (250) et le dispositif de transmission (170, 210) pour redresser le signal électrique du capteur, afin de transmettre le signal du capteur au dispositif de stockage (250) dans le même sens lors de l'évaluation du capteur, le dispositif redresseur (220) comprenant plusieurs redresseurs (220.1), de préférence des redresseurs unidirectionnels ou des redresseurs double alternance, qui sont connectés au dispositif de contrôle (100) et/ou au dispositif de contrôle (300) pour être commandés à des fréquences différentes, en particulier de manière cadencée et/ou cohérente et/ou synchronisée avec le signal de commande électrique, de telle sorte que

- l'un (220.1a) des redresseurs (220.1) ne transmet au dispositif de stockage (250) qu'une demi-oscillation du signal de capteur selon une fréquence fondamentale, en particulier une première harmonique, du signal électrique de capteur, et
- l'au moins un autre redresseur (220.1b, 220.1c) supprime la transmission, en particulier de cette demi-oscillation, du signal de capteur selon d'autres harmoniques du signal électrique de capteur au dispositif de stockage (250),

- un dispositif de contrôle (300) pour la détermination répétée d'au moins un paramètre spécifique à la détection, en particulier d'une capacité variable (CS), de l'élément de détection (20) à l'aide d'une évaluation au niveau du dispositif de stockage (250), en particulier de la quantité de charge qui y est stockée, afin d'effectuer la détection de l'action d'activation à l'aide des transferts de charge pour l'évaluation du capteur.

**2.** Dispositif (10) selon la revendication 1,
**caractérisé en ce que**
le dispositif redresseur (220) présente au moins un redresseur (220.1) pouvant être commandé, de préférence un redresseur synchrone, qui est réalisé de manière synchronisée, en particulier cohérente, par rapport au signal de commande pour le redressement du signal de capteur.

**3.** Dispositif (10) selon l'une quelconque des revendications précédentes,
**caractérisé en ce que**
le arrangement de contrôle (100) et/ou le dispositif de contrôle (300), de préférence un microcontrôleur (300), est connecté au dispositif redresseur (220) pour commander le dispositif redresseur (220) en fonction du signal de commande électrique et en particulier d'une phase du signal de commande électrique, de sorte que le redressement s'effectue de manière cohérente par rapport au signal de commande électrique et/ou de manière synchronisée par rapport à la commande électrique de l'élément de détection (20).

4. Dispositif (10) selon l'une quelconque des revendications précédentes,
**caractérisé en ce que**
le dispositif redresseur (220) présente au moins un commutateur électronique (220.2) qui est respectivement relié par un chemin de commande (220.3) avec l'arrangement de contrôle (100) et/ou le dispositif de contrôle (300) afin de relier électriquement, pour certaines demi-oscillations, en particulier des demi-oscillations négatives, du signal de commande électrique, le dispositif de stockage (250) au dispositif de transmission (170, 210) pour la transmission du signal de capteur électrique, un signal de commande du chemin de commande (220.3) étant synchronisé avec le signal de commande électrique pour la commutation du commutateur (220.2).

5. Dispositif (10) selon l'une quelconque des revendications précédentes,
**caractérisé en ce que**
le dispositif redresseur (220) présente plusieurs, de préférence au moins deux ou au moins trois ou au moins quatre, commutateurs électroniques (220.2) qui sont commandés par l'arrangement de contrôle (100) et/ou le dispositif de contrôle (300) avec des fréquences différentes pour supprimer des harmoniques du signal électrique de capteur, afin d'atténuer au moins un, en particulier le deuxième et/ou le troisième et/ou le quatrième harmonique du signal électrique de capteur.

6. Dispositif (10) selon l'une quelconque des revendications précédentes,
**caractérisé en ce que**
le dispositif redresseur (220) est conçu pour ne transmettre au dispositif de stockage (250), par des commutations répétées, qu'un transport de charge par le signal électrique de capteur en direction du dispositif de stockage (250), et de préférence pour ne relier un point zéro virtuel (250.B) du dispositif de stockage (250) au dispositif de transmission (170, 210) que lors de cette transmission, et de préférence sinon pour relier le dispositif de transmission (170, 210) à un potentiel de masse (21).

7. Dispositif (10) selon l'une quelconque des revendications précédentes,
**caractérisé en ce que**
est prévu un dispositif de filtrage d'évaluation (210) du dispositif de transmission (170, 210) pour mettre à disposition le signal électrique de capteur pour un transport de charge vers le dispositif de stockage (250) filtré, en particulier filtré en passe-bande, et de préférence comme signal de courant sinusoïdal.

8. Dispositif (10) selon l'une quelconque des revendications précédentes,
**caractérisé en ce que**
un agencement de contrôle de capteur (170) du dispositif de transmission (170, 210) est prévu et réalisé de manière à générer à une sortie (170.B), à l'aide des transferts de charge et à l'aide du signal de commande, un signal de tension électrique ayant une certaine fréquence et/ou une certaine forme de signal, de préférence une forme sinusoïdale, et un dispositif de filtre d'évaluation (210) du dispositif de transmission (170, 210) est conçu pour convertir, pour l'évaluation du capteur, le signal de tension en un signal de courant électrique ayant sensiblement la même forme de signal et/ou la même fréquence, de sorte que le signal de capteur est obtenu comme signal de courant électrique par une conversion de transconductance.

9. Dispositif (10) selon l'une quelconque des revendications précédentes,
**caractérisé en ce que**
l'élément capteur (20) est réalisé sous la forme d'une électrode de capteur (20) pour fournir le paramètre spécifique à la détection sous la forme d'une capacité variable (CS), la variation de la capacité (CS) étant spécifique à la variation dans l'environnement, le dispositif (10) étant réalisé à cet effet, à effectuer de manière répétée les transferts de charge entre l'élément de détection (20) et le dispositif de transmission (170, 210) en vue d'une détermination répétée pour l'évaluation du capteur, et à délivrer en fonction de cela le signal de capteur au dispositif de stockage (250), en particulier à un intégrateur (250), de sorte que la charge électrique stockée par le dispositif de stockage (250) est spécifique à la variation de la capacité (CS).

10. Dispositif (10) selon l'une quelconque des revendications précédentes,
**caractérisé en ce que**
le dispositif de contrôle (300) est connecté au dispositif de stockage (250) pour évaluer une charge électrique stockée par le dispositif de stockage (250) pour déterminer le paramètre spécifique à la détection, de préférence par une conversion analogique-numérique d'une tension au niveau du dispositif de stockage (250).

11. Dispositif (10) selon l'une quelconque des revendications précédentes,
**caractérisé en ce que**
le dispositif (10) est intégré au moins partiellement en tant qu'agencement de capteurs capacitifs dans un pare-chocs (1.1) du véhicule (1), afin de surveiller la zone arrière (1.2) du véhicule (1), et afin d'ouvrir, en tant que fonction sur le véhicule (1), le hayon (1.3) du véhicule (1), en particulier afin d'initier une émission d'un signal d'ouverture et/ou un contrôle d'authentification.

12. Système comprenant :

- un dispositif (10) selon l'une des revendications précédentes,
- le dispositif de contrôle (300) pour émettre un signal d'activation en cas de détection de l'action d'activation,
- un dispositif de commande (8) qui est relié au dispositif de contrôle (300) pour exécuter la fonction sur le véhicule (1) lors de la réception du signal d'activation.

13. Procédé pour un véhicule (1) pour la détection d'une action d'activation pour l'activation d'une fonction sur le véhicule (1), en particulier dans une zone avant, latérale et/ou arrière (1.2, 1.4, 1.7) du véhicule (1) pour l'activation d'une ouverture et/ou d'un déverrouillage d'un volet (1.3, 1.6) sur le véhicule (1), dans lequel on fait fonctionner un dispositif (10) selon l'une des revendications 1 à 11, dans lequel les étapes suivantes sont exécutées :

- Générer un signal de commande électrique,
- Effectuer des transferts de charge répétés au niveau de l'élément de détection (20) au moyen du signal de commande,
- Fournir un signal de capteur électrique sur la base des transferts de charge répétés et sur la base du signal de commande,
- Effectuer une transmission du signal de capteur dans le même sens vers un dispositif de stockage (250),
- Effectuer une détermination répétée d'au moins un paramètre spécifique à la détection, notamment une capacité variable (CS), de l'élément capteur (20) à partir d'une évaluation au niveau du dispositif de stockage (250), notamment de la quantité de charge qui y est stockée, afin d'effectuer la détection de l'action d'activation à partir des transferts de charge.

**Fig. 1**

EP 3 895 315 B1

Fig. 2

**Fig. 3**

**Fig. 4**

EP 3 895 315 B1

Fig. 5

**Fig. 6**

EP 3 895 315 B1

EP 3 895 315 B1

| 501 |

⇓

| 502 |

⇓

| 503 |

⇓

| 504 |

⇓

| 505 |

504

505

506

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016107910 A1
- US 20080252303 A1
- US 8564313 B1